# EUROPEAN PATENT SPECIFICATION

(11) **EP 2 622 672 B1**
(45) Date of publication and mention of the grant of the patent: **06.04.2016**
(21) Application number: 11784762.4
(22) Date of filing: 23.09.2011
(51) Int. Cl.: H01M 8/04, G01R 31/36, H01M 8/10

(54) **FUEL CELL SYSTEM, METHOD AND PROGRAM OF DETERMINING CAUSE OF NEGATIVE VOLTAGE, AND STORAGE MEDIUM STORING PROGRAM**
BRENNSTOFFZELLENSYSTEM, VERFAHREN UND PROGRAMM ZUR BESTIMMUNG DER URSACHE VON NEGATIVER SPANNUNG SOWIE SPEICHERMEDIUM MIT DARAUF GESPEICHERTEM PROGRAMM
SYSTÈME DE PILE À COMBUSTIBLE, PROCÉDÉ ET PROGRAMME PERMETTANT DE DÉTERMINER LA CAUSE D'UNE TENSION NÉGATIVE ET SUPPORT D'ENREGISTREMENT SUR LEQUEL LE PROGRAMME EST ENREGISTRÉ

(30) Priority: 28.09.2010 JP 2010216647
(43) Date of publication of application: 07.08.2013
(73) Proprietor: TOYOTA JIDOSHA KABUSHIKI KAISHA, Toyota-shi, Aichi-ken, 471-8571 (JP)
(72) Inventor: KAWAHARA, Shuya,, Toyota-shi, Aichi-ken, 471-8571 (JP); KATO, Manabu,, Toyota-shi, Aichi-ken, 471-8571 (JP); KUMEI, Hideyuki,, Toyota-shi, Aichi-ken , 471-8571 (JP)
(74) Representative: Kuhnen & Wacker
(86) International application number: PCT/IB2011/002183
(87) International publication number: WO 2012/042328

(56) References cited:
- EP-A2- 0 862 233
- WO-A1-2010/020861
- US-A1- 2006 057 447
- US-A1- 2010 136 447

## Description

### BACKGROUND OF THE INVENTION

### 1. Field of the Invention

The invention relates to a fuel cell, and particularly to a decrease in a cell voltage.

### 2. Description of Related Art

A fuel cell including a Membrane-Electrode Assembly (MEA), in which catalytic electrode layers are provided on both sides of an electrolyte membrane, is used. In the fuel cell, electric power is generated by an electrochemical reaction caused using a fuel gas (for example, a hydrogen gas) and an oxidant gas (for example, air). It is known that in the fuel cell, the voltage of the fuel cell (i.e., a potential difference between a cathode and an anode: hereinafter, referred to as "cell voltage") may decrease to a negative voltage due to the insufficiency of the amount of the fuel gas or the insufficiency of the amount of the oxidant gas. If the cell voltage becomes a negative voltage, for example, members (e.g., a platinum (Pt) catalyst and carbon) constituting a catalytic layer may deteriorate, resulting in significant deterioration of power generation performance. In this case, it is required to take a measure to increase the cell voltage from the negative voltage to a positive voltage. Because the measure to be taken varies depending on the cause of the negative voltage, there is demand for determining the cause of the negative voltage. Thus, Japanese Patent Application Publication No. JP 2008-130443 A describes a method in which a sweep current is rapidly increased in stepwise manner in a fuel cell, the rate of decrease in a cell voltage is measured, and the cause of a negative voltage is determined based on the rate of decrease in the cell voltage.

In the above-described technology in which the cause of the negative voltage is determined based on the rate of decrease in the cell voltage, there is only a small difference between the rate of decrease in the cell voltage when the amount of the fuel gas is insufficient, and the rate of decrease in the cell voltage when the amount of the oxidant gas is insufficient. Therefore, it is difficult to accurately determine the cause of the negative voltage. Further, it is assumed that the causes of the negative voltage include an increase in the resistance value of an electrolyte membrane (an increase in a resistance overvoltage) due to drying-up, in addition to the insufficiency of the amount of the fuel gas, and the insufficiency of the amount of the oxidant gas. However, in the above-described technology in which the cause of the negative voltage is determined based on the rate of decrease in the cell voltage, when the cause of the negative voltage is drying-up, it is not possible to determine that the cause of the negative voltage is drying-up.

Another fuel cell system is disclosed by US 2010/136447 A1. There, an IR resistance of each of unit cells is measured, and a highest unit cell voltage as a threshold voltage is set based on the IR resistance and load current. The setting of the highest unit cell voltage uses map data that approximates current-voltage characteristics of a unit cell when the fuel gas is insufficiently supplied. In that case, the highest unit cell voltage is determined based on the voltage with respect to the load current obtained from the map data, and the IR loss calculated from the IR resistance and the load current. This highest unit cell voltage is compared with the measured unit cell voltage. If the unit cell voltage is below the highest unit cell voltage, the power generation of the fuel cell is stopped or restrained.

From WO 2010/020861 A1, a fuel cell system is known that is provided with a voltage detection device that detects a cell voltage of a cell group containing one or more cells, a current density detection device that detects a generated current density of the cell group, and a determination portion that determines the presence or absence of an inflection point of a change in the cell voltage relative to the generated current density based on the detection results of the voltage detection device and the current density detection device.

### SUMMARY OF THE INVENTION

The invention accurately determines the cause of a negative voltage of a fuel cell, when the voltage of the fuel cell is the negative voltage.

A first aspect of the invention as set forth in claim 1 relates to a fuel cell system. The fuel cell system includes a fuel cell; a voltage measuring portion that measures a voltage of the fuel cell; an electric current adjusting portion that adjusts an electric current flowing in the fuel cell; an electric current-voltage characteristic information obtaining portion that controls the electric current adjusting portion to change the electric current, and obtains electric current-voltage characteristic information that is information indicating a correspondence relation between an electric current value and a voltage value measured by the voltage measuring portion; and a negative voltage cause determining portion that determines, if the voltage of the fuel cell is a negative voltage, a cause of the negative voltage of the fuel cell, based on the obtained electric current-voltage characteristic information.

In the fuel cell system according to the first aspect, the electric current-voltage characteristic information is obtained by changing the electric current and measuring the voltage, and the cause of the negative voltage of the fuel cell is determined based on the obtained electric current-voltage characteristic information. Therefore, it is possible to accurately determine the cause of the negative voltage. Also, because the determination is performed based on the electric current-voltage characteristic information, it is possible to detect, as the cause of the negative voltage, drying-up, in addition to insufficiency of the amount of hydrogen, and insufficiency of the amount of oxygen.

(cancelled)

(cancelled)

In the fuel cell system according to the above-described aspect, in the fuel cell, a fuel gas containing hydrogen and an oxidant gas containing oxygen are used as reaction gases; when the electric current-voltage characteristic information is obtained, the electric current-voltage characteristic information obtaining portion obtains the voltage value while changing the electric current in a pr range in which the electric current is higher than 0; the negative voltage cause determining portion determines a zero current-time voltage value that is the voltage value at a time when the electric current is 0, based on the obtained electric current-voltage characteristic information, using extrapolation; if the zero current-time voltage value is lower than 0 volt, the negative voltage cause determining portion determines that the cause is insufficiency of an amount of hydrogen; if the zero current-time voltage value is equal to or higher than 0 volt and lower than an open circuit voltage of the fuel cell at a normal time, the negative voltage cause determining portion determines that the cause is insufficiency of an amount of oxygen; and if the zero current-time voltage value is equal to or higher than the open circuit voltage, the negative voltage cause determining portion may determine that the cause is drying-up.

In the above-described configuration, it is possible to accurately detect, as the cause of the negative voltage of the fuel cell, the insufficiency of the amount of hydrogen, the insufficiency of the amount of oxygen, and the drying-up. Also, the electric current value range is decreased, as compared to the case in which the upper limit value of the electric current value range is the same as the upper limit value in the above-described configuration, and the lower limit value is 0. Therefore, it is possible to decrease the time period required to obtain the electric current-voltage characteristic information. Thus, it is possible to decrease the time period required to determine the cause of the negative voltage.

In the fuel cell system according to the above-described aspect, the fuel cell may include a catalytic layer, and an oxidant gas supply passage through which the oxidant gas is supplied to the catalytic layer; if the zero current-time voltage value is 0 volt, the negative voltage cause determining portion may determine that the cause is the insufficiency of the amount of oxygen due to blockage of the oxidant gas supply passage; and if the zero current-time voltage value is higher than 0 volt and lower than the open circuit voltage, the negative voltage cause determining portion may determine that the cause is the insufficiency of the amount of oxygen in a vicinity of the catalytic layer.

In the above-described configuration, if the cause of the negative voltage is the insufficiency of the amount of oxygen, it is possible to determine the cause of the insufficiency of the amount of oxygen. Accordingly, it is possible to select and execute an appropriate measure in accordance with the cause of the insufficiency of the amount of oxygen.

In the fuel cell system according to the above-described aspect, a lower limit value in the predetermined positive electric current value range may be higher than the electric current value at an inflection point of dV/dI in a case where the cause is the insufficiency of the amount of oxygen or the drying-up, the dV/dI indicating a change in the voltage value with respect to a change in the electric current value.

In the above-described configuration, the zero current-time voltage obtained using extrapolation is controlled to be in an appropriate voltage range in accordance with the cause of the negative voltage. Thus, it is possible to more accurately determine the cause of the negative voltage, based on the zero current-time voltage.

A fuel cell system according to another aspect of the invention as set forth in independent claim 4 comprises, a fuel cell, a voltage measuring portion that measures a voltage of the fuel cell, an electric current adjusting portion that adjusts an electric current flowing in the fuel cell, an electric current-voltage characteristic information obtaining portion that controls the electric current adjusting portion to change the electric current, and obtains electric current-voltage characteristic information that is information indicating a correspondence relation between an electric current value and a voltage value measured by the voltage measuring portion, and a negative voltage cause determining portion that determines, if the voltage of the fuel cell is a negative voltage, a cause of the negative voltage of the fuel cell, based on the obtained electric current-voltage characteristic information, wherein, in the fuel cell a fuel gas containing hydrogen and an oxidant gas containing oxygen are used as reaction gases; the negative voltage cause determining portion determines dV/dI that indicates a change in the voltage value with respect to a change in the electric current value, based on the electric current-voltage characteristic information; if there is not an electric current value range in which the dV/dI is constant, the negative voltage cause determining portion determines that the cause is insufficiency of an amount of hydrogen; if there is the electric current value range in which the dV/dI is constant and the voltage value at an inflection point of the dV/dI is lower than 0 volt, the negative voltage cause determining portion determines that the cause is insufficiency of an amount of oxygen; and if there is the electric current value range in which the dV/dI is constant and the voltage value at the inflection point is equal to or higher than 0 volt, the negative voltage cause determining portion determines that the cause is drying-up.

In the above-described configuration, it is possible to accurately detect, as the cause of the negative voltage of the fuel cell, the insufficiency of the amount of hydrogen, the insufficiency of the amount of oxygen, and the drying-up.

A fuel cell system according to still another aspect of the invention as set forth in independent claim 5 comprises, a fuel cell, a voltage measuring portion that measures a voltage of the fuel cell, an electric current adjusting portion that adjusts an electric current flowing in the fuel cell, an electric current-voltage characteristic information obtaining portion that controls the electric current adjusting portion to change the electric current, and obtains electric current-voltage characteristic information that is information indicating a correspondence relation between an electric current value and a voltage value measured by the voltage measuring portion, and a negative voltage cause determining portion that determines, if the voltage of the fuel cell is a negative voltage, a cause of the negative voltage of the fuel cell, based on the obtained electric current-voltage characteristic information, wherein, in the fuel cell, a fuel gas containing hydrogen and an oxidant gas containing oxygen are used as reaction gases; the fuel cell include a catalytic layer, and an oxidant gas supply passage through which the oxidant gas is supplied to the catalytic layer; the negative voltage cause determining portion determines dV/dI that indicates a change in the voltage value with respect to a change in the electric current value, based on the electric current-voltage characteristic information; if there is not an electric current value range in which the dV/dI is constant, the negative voltage cause determining portion determines that the cause is insufficiency of an amount of hydrogen; if there is the electric current value range in which the dV/dI is constant and there is not an inflection point of the dV/dI, the negative voltage cause determining portion determines that the cause is insufficiency of an amount of oxygen due to blockage of the oxidant gas supply passage; and if there is the electric current value range in which the dV/dI is constant and the voltage value at the inflection point of the dV/dI is lower than 0 volt, the negative voltage cause determining portion determines that the cause is the insufficiency of the amount of oxygen in a vicinity of the catalytic layer.

In the fuel cell system according to the above-described aspect, if there is not an electric current value range in which the dV/dI is constant, the negative voltage cause determining portion may determine that the cause is insufficiency of an amount of hydrogen; if there is the electric current value range in which the dV/dI is constant and there is not an inflection point of the dV/dI, the negative voltage cause determining portion may determine that the cause is insufficiency of an amount of oxygen due to blockage of the oxidant gas supply passage; if there is the electric current value range in which the dV/dI is constant and the voltage value at the inflection point of the dV/dI is lower than 0 volt, the negative voltage cause determining portion may determine that the cause is the insufficiency of the amount of oxygen in a vicinity of the catalytic layer; and if there is the electric current value range in which the dV/dI is constant and the voltage value at the inflection point is equal to or higher than 0 volt, the negative voltage cause determining portion may determine that the cause is drying-up.

In the above-described configuration, if the cause of the negative voltage is the insufficiency of the amount of oxygen, it is possible to determine the cause of the insufficiency of the amount of oxygen. Accordingly, it is possible to select and execute an appropriate measure in accordance with the cause of the insufficiency of the amount of oxygen.

The fuel cell system according to the above-described aspects may further include a temperature adjusting portion that adjusts a temperature of the fuel cell to 0°C or higher, if it is determined that the cause is the insufficiency of the amount of oxygen due to the blockage of the oxidant gas supply passage; and an oxidant gas supply portion that increases an amount of the oxidant gas supplied to the fuel cell, if it has been determined that the cause is the insufficiency of the amount of oxygen due to the blockage of the oxidant gas supply passage and the temperature of the fuel cell has been adjusted to 0 °C or higher.

In the above-described configuration, in the case where the oxidant gas supply passage is blocked due to the accumulation of water generated by electric power generation in the fuel cell, the saturated vapor pressure is increased to make it easier to discharge the generated water that is accumulated, by adjusting the temperature of the fuel cell to 0 °C or higher. In addition, the amount of the supplied oxidant gas is increased after the temperature of the fuel cell is adjusted to 0 °C or higher to make it easier to discharge the generated water. Therefore, the generated water is easily discharged from the oxidant gas supply passage, and the amount of oxygen becomes sufficient.

The fuel cell system according to the above-described aspect may further include a malfunction detecting portion that detects that a malfunction has occurred in the fuel cell system, if the voltage value is a negative voltage value after the amount of the supplied oxidant gas is increased by the oxidant gas supply portion.

In the above-described configuration, if the oxidant gas supply passage is blocked due to a cause other than the generated water, it is possible to detect that a malfunction has occurred in the fuel cell system. Accordingly, for example, an appropriate measure is taken in response to the detection of the occurrence of a malfunction. For example, notification is provided to a manager, or a log is stored.

The fuel cell system according to the above-described aspect may further include an oxidant gas supply portion that increases an amount of the oxidant gas supplied to the fuel cell, if it is determined that the cause is the insufficiency of the amount of oxygen; a fuel gas supply portion that increases an amount of the fuel gas supplied to the fuel cell, if it is determined that the cause is the insufficiency of the amount of hydrogen; and a humidification portion that humidifies the fuel cell, if it is determined that the cause is the drying-up.

In the above-described configuration, it is possible to take an appropriate measure in accordance with the cause of the negative voltage. Accordingly, the voltage of the fuel cell is quickly increased from the negative voltage to a positive voltage. Thus, it is possible to reduce the possibility that a failure occurs, for example, members constituting the catalytic layer deteriorate, due to the negative voltage.

Other aspects of the invention relate to a method of determining a cause of a negative voltage of a fuel cell as set forth in independent claims 11 to 13. The method includes obtaining an electric current-voltage characteristic information that is information indicating a correspondence relation between an electric current value and a voltage value, by changing an electric current flowing in the fuel cell, and measuring a voltage of the fuel cell; and determining the cause of the negative voltage of the fuel cell, based on the obtained electric current-voltage characteristic information.

In the methods according to the other aspects, the electric current-voltage characteristic information is obtained by changing the electric current and measuring the voltage, and the cause of the negative voltage of the fuel cell is determined based on the obtained electric current-voltage characteristic information. Therefore, it is possible to accurately determine the cause of the negative voltage. Also, because the determination is performed based on the electric current-voltage characteristic information, it is possible to detect, as the cause of the negative voltage, drying-up, in addition to insufficiency of the amount of hydrogen, and insufficiency of the amount of oxygen.

(cancelled)

In the above-described configuration, it is determined whether the cause of the negative voltage of the fuel cell is the insufficiency of the amount of hydrogen, or a cause other than the insufficiency of the amount of hydrogen. Therefore, if it is determined that the cause is the insufficiency of the amount of hydrogen, it is possible to take an appropriate measure.

(cancelled)

(cancelled)

(cancelled)

(cancelled)

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG 1 is an explanatory diagram showing the schematic configuration of a fuel cell system according to an embodiment of the invention;
FIG 2 is a flowchart showing steps of negative voltage cause determining processing in a first embodiment;
FIG 3 is an explanatory diagram showing an I-V characteristic obtained in step S105;
FIG 4 is an explanatory diagram schematically illustrating the reason why an I-V characteristic curve at a normal time is derived;
FIG 5 is an explanatory diagram schematically illustrating the reason why the I-V characteristic curve in the case where the amount of hydrogen is insufficient is derived;
FIG 6 is an explanatory diagram schematically illustrating the reason why the I-V characteristic curve in the case where the amount of oxygen is insufficient is derived;
FIG 7 is an explanatory diagram schematically illustrating the reason why the I-V characteristic curve in a dry-up state is derived;
FIG 8 is a flowchart showing steps of cell voltage recovery processing in the first embodiment;
FIG 9 is a flowchart showing steps of negative voltage cause determining processing in a second embodiment;
FIG 10 is an explanatory diagram showing examples of a zero current-time voltage value determined in step S310;
FIG 11 is an explanatory diagram showing a region in which a straight line obtained through straight-line approximation may exist, with regard to each cause of a negative voltage;
FIG. 12 is a flowchart showing steps of negative voltage cause determining processing in a third embodiment;
FIG 13 is an explanatory diagram showing the I-V characteristic curve obtained in step S105 in the case where the amount of oxygen is insufficient due to the blockage of a passage;
FIG 14 is an explanatory diagram showing the I-V characteristic curve obtained in step S105 in the case where the amount of oxygen is insufficient in the vicinity of a catalytic layer;
FIG 15 is a flowchart showing steps of cell voltage recovery processing in the third embodiment;
FIG 16 is a flowchart showing steps of negative voltage cause determining processing in a fourth embodiment; and
FIG 17 is an explanatory diagram showing examples of the zero current-time voltage value obtained in step S310 in the fourth embodiment.

### DETAILED DESCRIPTION OF EMBODIMENTS

### A. First embodiment

### A1. System configuration

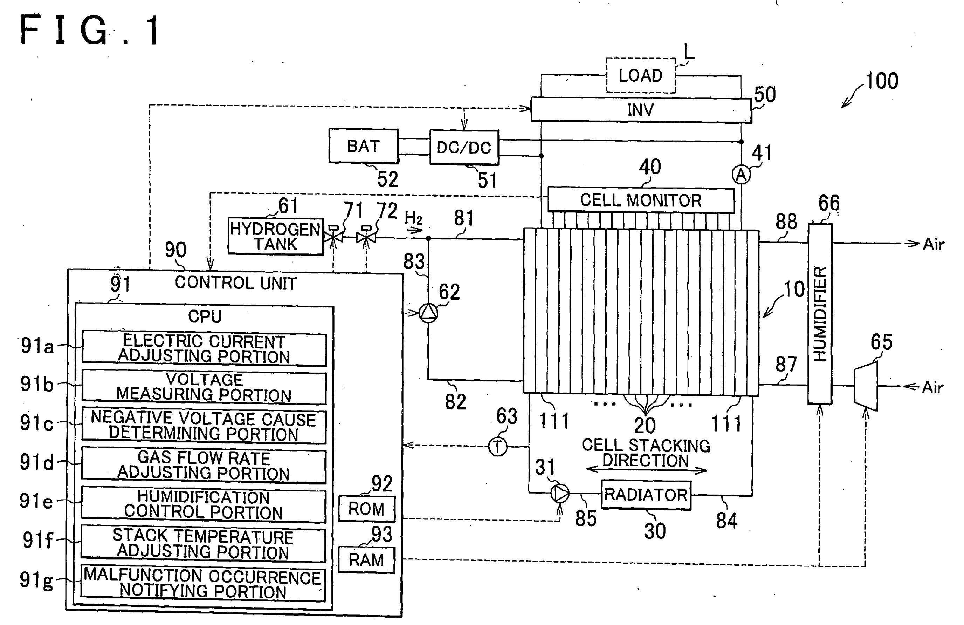

FIG 1 is an explanatory diagram showing the schematic configuration of a fuel cell system according to an embodiment of the invention. In the embodiment, a fuel cell system 100 is provided in an electric vehicle and is used as a system that supplies power for driving the electric vehicle. The fuel cell system 100 includes a fuel cell stack 10, a hydrogen tank 61, a shutoff valve 71, a pressure adjusting valve 72, a first circulation pump 62, an air compressor 65, a humidifier 66, a radiator 30, a second circulation pump 31, a temperature sensor 63, a cell monitor 40, an electric current sensor 41, a DC-DC converter 51, a secondary battery 52, an inverter 50, a control unit 90, a fuel gas supply passage 81, a fuel gas discharge passage 82, a bypass passage 83, an oxidant gas supply passage 87, an oxidant gas discharge passage 88, a cooling medium supply passage 84, and a cooling medium discharge passage 85.

The fuel cell stack 10 has a structure in which a plurality of unit cells 20 are stacked. Each unit cell is a polymer electrolyte fuel cell. In the fuel cell stack 10, an electrochemical reaction is caused at each electrode using pure hydrogen, which is a fuel gas, and oxygen in air, which is an oxidant gas, whereby an electromotive force is obtained. In the unit cell 20, both surfaces of a Membrane-Electrode Assembly (MEA) (not shown) are sandwiched between two gas diffusion layers. Further, the MEA and the gas diffusion layers are sandwiched between two separators. Two terminal plates 111, which are overall electrodes, are disposed at both ends of the stacked unit cells 20.

The hydrogen tank 61 stores a high-pressure hydrogen gas, and supplies the hydrogen gas, which is the fuel gas, to the fuel cell stack 10 via the fuel gas supply passage 81. For example, a tank that includes a hydrogen storing alloy therein may be employed as the hydrogen tank 61. In this case, hydrogen is stored in the hydrogen storing alloy, and thus, the tank stores hydrogen.

The shutoff valve 71 is disposed at a hydrogen gas outlet (not shown) of the hydrogen tank 61. The shutoff valve 71 allows and stops the supply of the hydrogen gas. The pressure adjusting valve 72 is disposed in the fuel gas supply passage 81. The pressure adjusting valve 72 decreases the pressure of the high-pressure hydrogen gas discharged from the hydrogen tank 61 to a given pressure. The first circulation pump 62 is disposed in the bypass passage 83. The first circulation pump 62 supplies an anode-side off gas (i.e., a surplus hydrogen gas that has not been used in the electrochemical reaction), which has been discharged from the fuel cell stack 10 via the fuel gas discharge passage 82, to the fuel gas supply passage 81.

The air compressor 65 is disposed in the oxidant gas supply passage 87. The air compressor 65 pressurizes air, which has been taken into the air compressor 65 from an outside, and supplies the pressurized air to the fuel cell stack 10. The humidifier 66 is disposed to extend from the oxidant gas supply passage 87 to the oxidant gas discharge passage 88. In the humidifier 66, moisture is exchanged between relatively dry air supplied from the air compressor 65 and a relatively moist gas discharged from the oxidant gas discharge passage 88 (i.e., a cathode-side off gas containing generated water). Thus, the humidifier 66 humidifies air to be supplied to the fuel cell stack 10.

The radiator 30 is connected to the cooling medium supply passage 84 and the cooling medium discharge passage 85. In the radiator 30, heat is exchanged between a cooling medium (coolant, air, and the like) discharged from the fuel cell stack 10, and outside air. Thus, the radiator 30 supplies the cooling medium that has been subjected to heat exchange, to the fuel cell stack 10 via the cooling medium supply passage 84. The second circulation pump 31 is disposed in the cooling medium discharge passage 85. The second circulation pump 31 supplies the cooling medium discharged from the fuel cell stack 10, to the radiator 30. The temperature sensor 63 is disposed at the second circulation pump 31, and measures the temperature of the cooling medium discharged from the fuel cell stack 10. In the fuel cell system 100, the temperature measured by the temperature sensor 63 is used as the temperature of the fuel cell stack 10.

The cell monitor 40 is connected to the unit cells 20, and measures the cell voltage (i.e., a potential difference between a cathode electrode and an anode electrode) of each unit cell 20. The electric current sensor 41 is connected in series to the fuel cell stack 10, and measures the value of an electric current flowing in the fuel cell stack 10. The DC-DC converter 51 is connected in parallel to the fuel cell stack 10 and the secondary battery 52. The DC-DC converter 51 increases the voltage output from the secondary battery 52, and then supplies the increased voltage to the inverter 50. Also, in order to store surplus electric power generated by the fuel cell stack 10, the DC-DC converter 51 decreases the voltage output from the fuel cell stack 10, and then supplies the decreased voltage to the secondary battery 52. The inverter 50 is connected in parallel to the fuel cell stack 10 and the DC-DC converter 51. The inverter 50 converts a DC current supplied from the fuel cell stack 10 or the DC-DC converter 50, to an AC current, and supplies the AC current to a load L (for example, a motor for driving the vehicle).

The control unit 90 is electrically connected to the air compressor 65, the humidifier 66, the shutoff valve 71, the pressure adjusting valve 72, the first circulation pump 62, the second circulation pump 31, the inverter 50, and the DC-DC converter 51. The control unit 90 controls these elements, that is, the air compressor 65, the humidifier 66, the shutoff valve 71, the pressure adjusting valve 72, the first circulation pump 62, the second circulation pump 31, the inverter 50, and the DC-DC converter 51. Also, the control unit 90 is connected to the temperature sensor 63, and obtains the temperature measured by the temperature sensor 63.

Also, the control unit 90 includes a Central Processing Unit (CPU) 91, a Read Only Memory (ROM) 92, and a Random Access Memory (RAM) 93. The ROM 92 stores control programs (not shown) for controlling the fuel cell system 100. The CPU 91 functions as an electric current adjusting portion 91 a, a voltage measuring portion 91 b, a negative voltage cause determining portion 91 c, a gas flow rate adjusting portion 91d, a humidification control portion 91e, a stack temperature adjusting portion 91f, and a malfunction occurrence notifying portion 91g, by executing the control programs using the RAM 93.

The electric current adjusting portion 91a controls the DC-DC converter 51, thereby adjusting the electric current flowing in the fuel cell stack 10. The voltage measuring portion 91b obtains the value of the voltage of each unit cell 20. The voltage measuring portion 91 b is notified of the value of the voltage of each unit cell 20 by the cell monitor 40. When the voltage of the unit cell 20 is a negative voltage, the negative voltage cause determining portion 91c determines the cause of the negative voltage. The gas flow rate adjusting portion 91d adjusts the amounts of the hydrogen gas and air that are supplied to the fuel cell stack 10. More specifically, the gas flow rate adjusting portion 91d adjusts the amount of the hydrogen gas supplied to the fuel cell stack 10 by adjusting the opening degrees of the shutoff valve 71 and the pressure adjusting valve 72. Also, the gas flow rate adjusting portion 91 d adjusts the amount of air supplied to the fuel cell stack 10 by controlling the rotational speed of the air compressor 65. The humidification control portion 91e adjusts the amount of humidification of air supplied to the fuel cell stack 10 by controlling the humidifier 66. The stack temperature adjusting portion 91f adjusts the temperature of the fuel cell stack 10 by controlling the second circulation pump 31 to adjust the flow rate of the cooling medium that flows in the cooling medium supply passage 84 and the cooling medium discharge passage 85. The malfunction occurrence notifying portion 91g detects the malfunction of the fuel cell system 100, and provides notification. More specifically, when the malfunction occurrence notifying portion 91 g detects the malfunction of the system, the malfunction occurrence notifying portion 91g causes an operation panel (not shown) to indicate that a malfunction has occurred.

The value of the open-circuit voltage of the fuel cell stack 10 (i.e., cell voltage in the case where the load L is not connected to the fuel cell stack 10: OCV) at a normal time, and various threshold values are preliminarily stored in the above-described ROM 92.

In the fuel cell system 100, when the cell voltage of any one of the unit cells 20 constituting the fuel cell stack 10 is a negative voltage, negative voltage cause determining processing (described later) is executed to determine the cause of the negative voltage. Also, in the fuel cell system 100, cell voltage recovery processing (described later) is executed, whereby a measure is taken in accordance with the determined cause of the negative voltage. Thus, the cell voltage is increased from a negative voltage to a positive voltage.

The voltage measuring portion 91 b may be regarded as the voltage measuring portion and the electric current-voltage characteristic information obtaining portion according to the invention. The gas flow rate adjusting portion 91 d and the air compressor 65 may be regarded as the oxidant gas supply portion according to the invention. The gas flow rate adjusting portion 91d, the shutoff valve 71, and the pressure adjusting valve 72 may be regarded as the fuel gas supply portion according to the invention. The humidification control portion 91e and the humidifier 66 may be regarded as the humidification portion according to the invention. The malfunction occurrence notifying portion 91g may be regarded as the malfunction detecting portion according to the invention.

### A2. Negative voltage cause determining processing

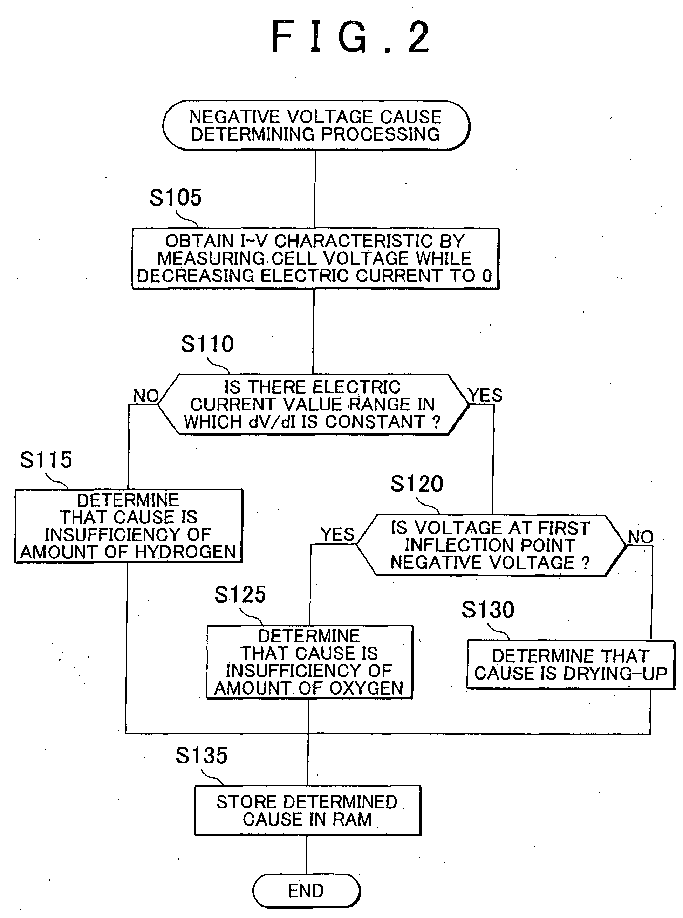

FIG 2 is a flowchart showing steps of the negative voltage cause determining processing in the first embodiment. In the fuel cell system 100, the cell voltages of the unit cells 20 are constantly monitored. When the voltage of any one of the unit cells 20 is a negative voltage, the negative voltage cause determining processing is started.

The electric current adjusting portion 91a decreases the electric current from the electric current value in the state in which the negative voltage is measured, to the electric current value of 0. The voltage measuring portion 91b measures the cell voltage at each electric current value, and causes the RAM 93 to store the cell voltage at each electric current value as an electric current-voltage characteristic (hereinafter, referred to as "I-V characteristic") (step S105). At this time, the electric current adjusting portion 91a may decrease the electric current in a stepwise manner, or may continuously decrease the electric current. When the electric current is decreased in a stepwise manner, the voltage measuring portion 91 b may obtain the voltage value in each step. Also, when the electric current is continuously decreased, the voltage measuring portion 91b may obtain the voltage value in each predetermined current interval. The cell voltage at each electric current value (i.e., I-V characteristic curve), which is obtained in step S105, may be regarded as the electric current-voltage characteristic information according to the invention.

The negative voltage cause determining portion 91c determines whether there is an electric current value range in which the change in the voltage with respect to the change in the electric current (dV/dI) is constant, based on the I-V characteristic obtained in step S105 (step S110).

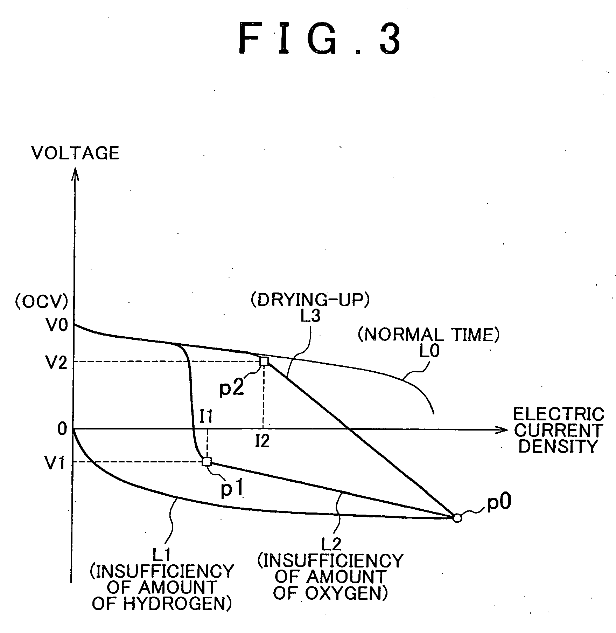

FIG 3 is an explanatory diagram showing the I-V characteristic obtained in step S105. In FIG. 3, an abscissa axis indicates the electric current density (electric current), and an ordinate axis indicates the voltage value (cell voltage). In FIG 3, a curve L0 indicates the I-V characteristic curve of the unit cell 20 at a normal time (i.e., when electric power is generated while the amount of the supplied hydrogen gas and the amount of supplied air are larger than the amounts required for electric power generation). An operating point p0 is an operating point at a time point at which the negative voltage cause determining processing is started. A curve L1 indicates the I-V characteristic curve obtained when the process in step S105 is executed in the case where the amount of the hydrogen gas is insufficient. A curve L2 indicates the I-V characteristic curve obtained when the process in step S105 is executed in the case where the amount of oxygen (air) is insufficient. A curve L3 indicates the I-V characteristic curve obtained when the process in step S105 is executed in a dry-up state.

As shown in FIG 3, the voltage value at the operating point p0 at the time point, at which the negative voltage cause determining processing is started, is a negative voltage value. When the electric current is decreased in the case where the amount of hydrogen is insufficient, the voltage value gradually increases, and when the electric current becomes 0 (the electric current = 0), the voltage value becomes 0 (the voltage value = 0), as shown by the curve L1. In this case, dV/dI (i.e., the inclination of the tangent at each point on the curve L1) continuously changes, and there is not an electric current value range in which dV/dI is constant.

When the electric current is decreased in the case where the amount of oxygen is insufficient, dV/dI is constant and the voltage value linearly increases in a range from the operating point p0 to an operating point p1 (at which the electric current value is I1 (the electric current value = I1), and the voltage value is V1 (the voltage value = V1)), as shown by the curve L2. Note that the voltage value V1 at the operating point p1 is a negative voltage value. The operating point p1 is an inflection point, that is, dV/dI sharply increases from the operating point p1, and the voltage value becomes a positive voltage value. Then, dV/dI decreases, and the curve L2 coincides with the curve L0.

When the electric current is decreased in the dry-up state, dV/dI is constant and the voltage linearly increases in a range from the operating point p0 to an operating point p2 (at which the electric current value is I2 (the electric current value = 12), and the voltage value is V2 (the voltage value = V2)), as shown by the curve L3. Note that the voltage value V2 at the operating point p2 is a positive voltage value. The operating point p2 is an inflection point, that is, dV/dI decreases from the operating point p2, and the L3 coincides with the curve L0.

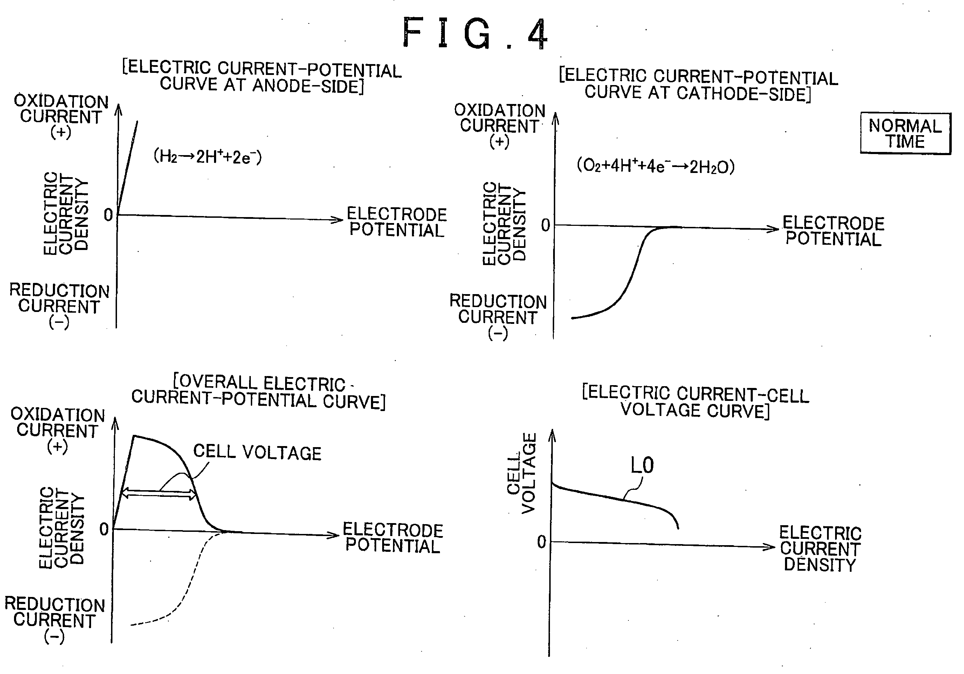

Accordingly, in the case where the amount of oxygen is insufficient or in the case where drying-up has occurred, there is the electric current value range in which dV/dI is constant. In the case where the amount of hydrogen is insufficient, there is not the electric current value range in which dV/dI is constant. The reason why the I-V characteristic curve varies according to the cause of the negative voltage will be described with reference to FIG 4 to FIG 7.

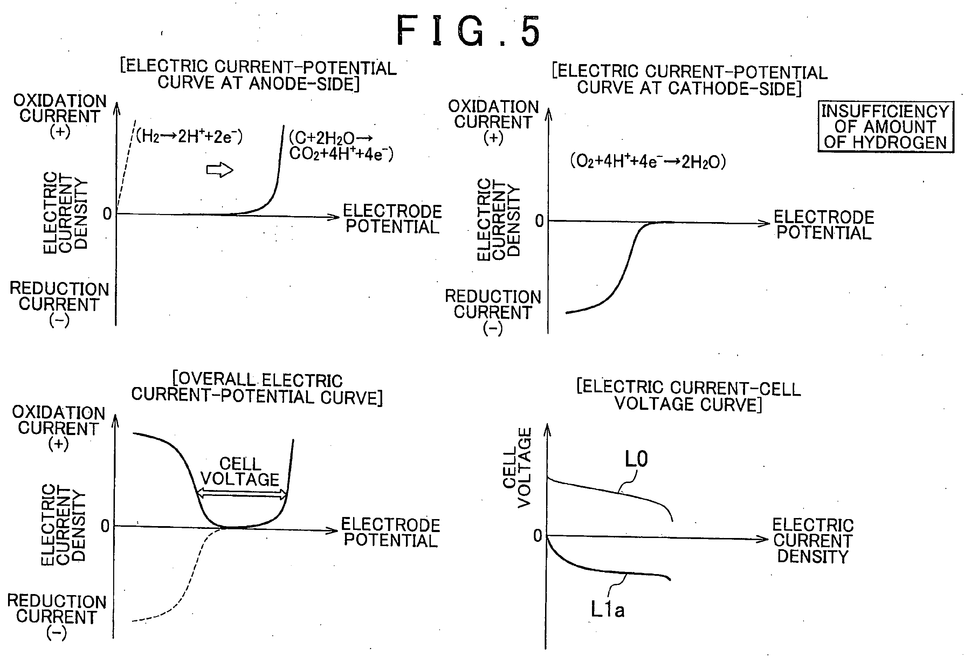

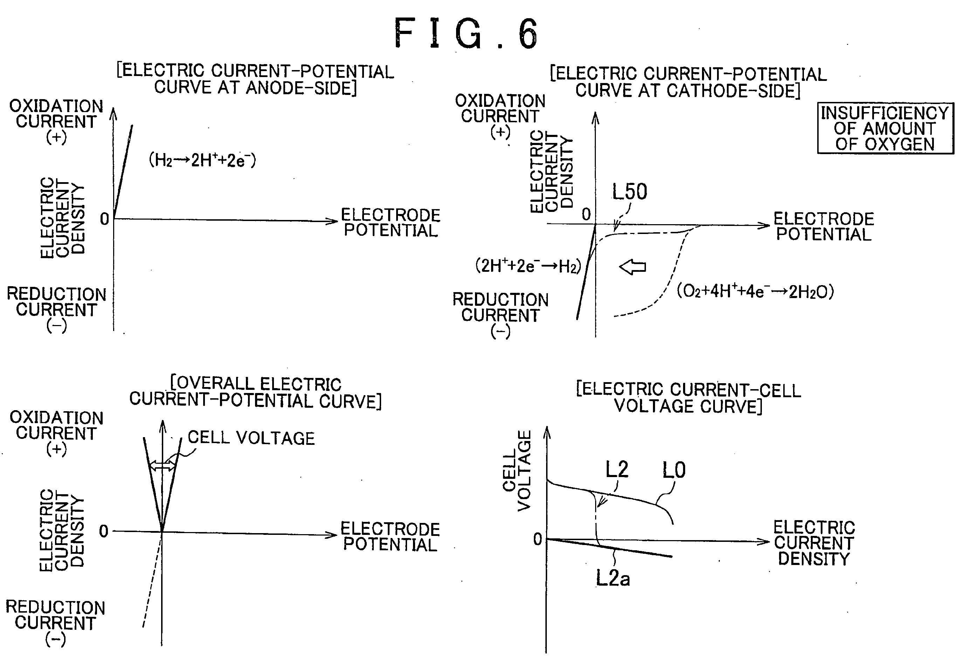

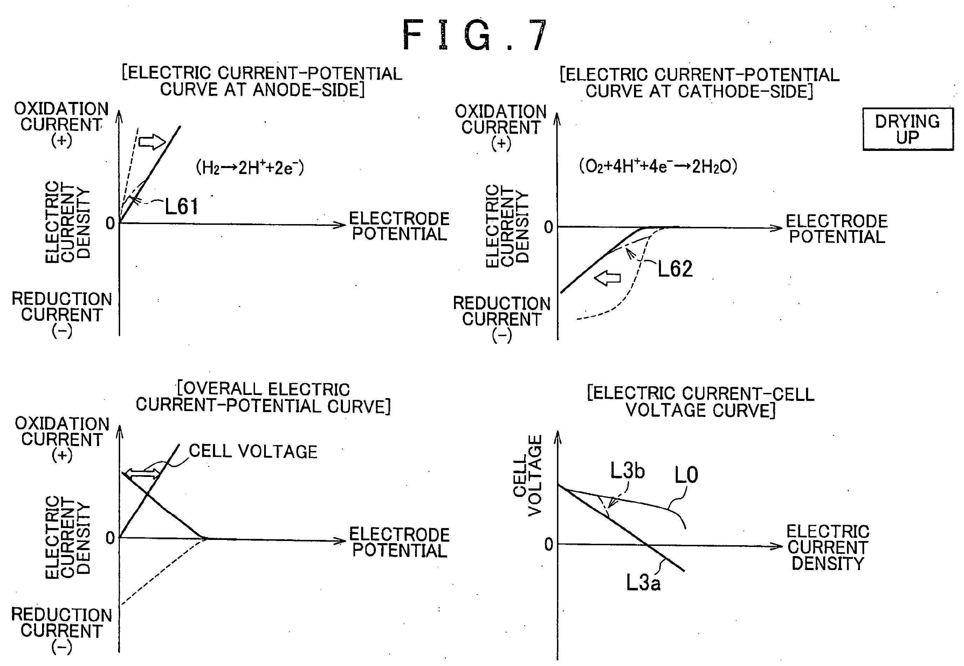

FIG 4 shows an explanatory diagram schematically illustrating the reason why the I-V characteristic curve at the normal time is derived. FIG 5 is an explanatory diagram schematically illustrating the reason why the I-V characteristic curve in the case where the amount of hydrogen is insufficient is derived. FIG 6 is an explanatory diagram schematically illustrating the reason why the I-V characteristic curve in the case where the amount of oxygen is insufficient is derived. FIG 7 is an explanatory diagram schematically illustrating the reason why the I-V characteristic curve in the dry-up state is derived.

Each of FIG 4 to FIG 7 includes four graphs. In each of FIG 4 to FIG 7, the upper left graph shows the relation between the electrode potential and the electric current density at the anode side, the upper right graph shows the relation between the electrode potential and the electric current density at the cathode side, the lower right graph shows the relation between the electric current density and the cell voltage in the entire unit cell 20, and the lower left graph shows how to determine the cell voltage based on the relation between each electrode potential and the electric current density. In each of FIG 4 to FIG 7, the electric current generated by the oxidation reaction is indicated as a positive electric current, and the electric current generated by the reduction reaction is indicated as a negative electric current, for the sake of convenience.

As shown in the upper left graph in FIG 4, a reaction represented by the equation (1) described below occurs at the anode-side at the normal time. As the electric current (oxidation current) increases, the anode potential linearly increases.

*H*₂*→*2*H⁺*+2*e⁻* (1)

As shown in the upper right graph in FIG 4, a reaction represented by the equation (2) described below occurs at the cathode-side at the normal time. As the electric current (reduction current) increases, the cathode potential decreases.

*O*₂+4*H*⁺+4*e*⁻→2*H*₂*O* (2)

As shown in the lower left graph in FIG 4, the potential difference between the cathode potential and the anode potential is the cell voltage. In the lower left graph in FIG 4, the electric current generated by the reduction reaction is converted from a negative current to a positive current for the following reason. In each of the upper left graphs and the upper right graphs in FIG 4 to FIG 7, the oxidation current is indicated as a positive electric current, and the reduction current is indicated as a negative electric current, for the sake of convenience. However, the cell voltage is determined by subtracting the anode potential from the cathode potential at the same absolute value of the electric current value.

Then, the I-V characteristic curve (i.e., the curve L0) shown in the lower right graph is obtained by determining the potential difference between the electrode potentials, as the cell voltage, at each electric current value (at each absolute value of the electric current value).

In the case where the amount of hydrogen is insufficient, a reaction represented by the equation (3) described below occurs at the anode-side, instead of the reaction represented by the equation (1), as shown in the upper left graph in FIG 5. This is because the amount of protons generated by the reaction represented by the equation (1) decreases due to the insufficiency of the amount of hydrogen, and therefore, carbon of a catalyst is oxidized, and thus, protons are generated to compensate for the decrease in the amount of protons.

*C*+2*H*₂*O→CO*₂+4*H*⁺4*e⁻* (3)

When the reaction represented by the equation (3) occurs, the anode potential becomes higher than the anode potential at the normal time (i.e., when the reaction represented by the equation (1) occurs). The degree of increase in the anode potential due to the increase in the electric current gradually increases. As shown in the upper right graph in FIG 5, the cathode potential is the same as the cathode potential at the normal time. Therefore, as shown in the lower left graph in FIG 5, the anode potential exceeds the cathode potential. As a result, as shown in the lower right graph in FIG. 5, as the electric current increases, the cell voltage gradually decreases in a negative voltage range. Thus, an I-V characteristic curve L1a, which is similar to the curve L1 in FIG 3, is obtained.

Once the amount of hydrogen becomes insufficient, the amount of hydrogen remains insufficient even when the value of the electric current is decreased to a value close to 0. Therefore, the I-V characteristic curve L1a does not contact the I-V characteristic curve L0 at the normal time for the following reason, as shown in the lower right graph in FIG 5. When the catalyst (Pt) is oxidized due to the insufficiency of the amount of hydrogen, oxide (e.g., platinum oxide) becomes inactive in the oxidation reaction of hydrogen (i.e., the reaction represented by the equation (1)). Therefore, even when the electric current value decreases and the amount of supplied hydrogen becomes sufficient, protons are not sufficiently generated by the oxidation reaction of hydrogen (i.e., the reaction represented by the equation (1)). As a result, the reaction represented by the equation (3) occurs.

In the case where the amount of oxygen is insufficient, a reaction represented by the equation (4) described below occurs at the cathode-side, instead of the reaction represented by the equation (2), as shown in the upper right graph in FIG 6. This is because the amount of protons reduced by the reaction represented by the equation (2) decreases due to the insufficiency of the amount of oxygen, and therefore, protons are reduced by the reaction represented by the equation (4) to compensate for the decrease in the amount of reduced protons.

2*H*⁺+2*e⁻→H*₂ (4)

When the reaction represented by the equation (4) occurs, the cathode potential becomes lower than the cathode potential in the normal state, and becomes a negative potential. As shown in the upper left graph in FIG 6, the anode potential is the same as the anode potential at the normal time. Therefore, as shown in the lower left graph in FIG 6, the anode potential exceeds the cathode potential. As a result, as shown in the lower right graph in FIG 6, as the electric current increases, the cell voltage linearly decreases in the negative voltage range. Thus, an I-V characteristic curve L2a is obtained.

FIG. 6 shows the electrode potentials and the cell voltage in the case where the amount of oxygen remains insufficient even when the electric current (electric current density) is decreased to a value close to 0. In this case, no oxygen is supplied to the cathode-side (i.e., a cathode-side catalytic layer). In contrast, in the case where a small amount of oxygen is supplied, as the electric current decreases, the amount of oxygen becomes sufficient at a certain electric current value. When the value of the electric current flowing in the fuel cell stack 10 is low, the amount of oxygen required to generate the low electric current is small, and therefore, the amount of oxygen becomes sufficient. In this case where a small amount of oxygen is supplied, when the electric current value is relatively low, the reaction represented by the equation (2) occurs, and when the electric current value is relatively high, the reaction represented by the equation (4) occurs, as shown by a curve L50 that is a chain line in the upper right graph in FIG 6. As a result, the I-V characteristic curve, which is the same as the curve L2 in FIG 3, is obtained, as shown by a chain line in the lower right graph in FIG 6.

In the dry-up state, the reactions, which are the same as the reactions at the normal time, occur in the anode-side and the cathode-side, respectively, as shown in the upper left graph and the upper right graph in FIG 7. However, the shapes of the curve and the straight line are different from those at the normal time, as a result of an increase in the resistance of an electrolyte membrane due to drying-up. Consequently, there is a range in which the cathode potential is lower than the anode potential, as shown in the lower left graph in FIG 7. Thus, as shown in the lower right graph in FIG 7, as the electric current increases, the cell voltage linearly decreases from a positive voltage, and continues to decrease even after the cell voltage becomes a negative voltage. Thus, an I-V characteristic curve L3a is obtained.

FIG 7 shows the electrode potentials and the cell voltage in the case where, even when the electric current (electric current density) is decreased to a value close to 0, the unit cell 20 remains in the dry-up state. In actuality, when the electric current is decreased, much electric power is not generated (that is, the reactions represented by the equations (1) and (2) are curbed), and therefore, the cell temperature decreases. As a result, the humidity inside the unit cell 20 increases, and the unit cell 20 is no longer in the dry-up state. Accordingly, when (the absolute value of) the electric current value is relatively low, the electric current-potential curve coincides with the electric current-potential curve at the normal time, as shown by curves L61 and L62 that are chain lines in the upper left graph and the upper right graph in FIG 7. As a result, as shown in the lower right graph in FIG 7, an I-V characteristic curve Lb3, which is similar to the I-V characteristic curve L3 in FIG 3, is obtained. The shapes of the electric current-potential curves at the respective electrodes may be changed according to the degree of dryness of the electrolyte membrane. The shape of the curve L3b in the lower right graph in FIG 7 differs from the curve L3 in FIG 3, because the degree of dryness of the electrolyte membrane when measurement is performed to obtain the curve L3b differs from the degree of dryness of the electrolyte membrane when measurement is performed to obtain the curve L3.

Referring to FIG. 2 again, if it is determined that there is not the electric current value range in which dV/dI is constant (NO in step S110), the negative voltage cause determining portion 91c determines that the cause of the negative voltage is the insufficiency of the amount of hydrogen (step S115), and causes the RAM 93 to store the determined cause (step S135).

If it is determined that there is the electric current value range in which dV/dI is constant (YES in step S110), the negative voltage cause determining portion 91 c determines whether the voltage at the first inflection point obtained when the electric current is decreased, in the I-V characteristic curve obtained in step S105, is a negative voltage (step S120). If it is determined that the voltage at the first inflection point obtained when the electric current is decreased is a negative voltage (YES in step S120), the negative voltage cause determining portion 91c determines that the cause of the negative voltage is the insufficiency of the amount of oxygen (step S125), and causes the RAM 93 to store the determined cause (step S135). In contrast, if it is determined that the voltage at the first inflection point obtained when the electric current is decreased is equal to or higher than 0 volt (NO in step S120), the negative voltage cause determining portion 91c determines that the cause of the negative voltage is drying-up (step S130), and causes the RAM 93 to store the determined cause (step S135).

In the case where the amount of oxygen is insufficient, the voltage value V1 at the first inflection point (the operating point p1) is a negative voltage value as shown by the curve L2 in FIG 3. In contrast, in the dry-up state, the voltage value V2 at the first inflection point (the operating point p2) is a positive voltage value, as shown by the curve L3 in FIG 3. Thus, it has been found that in the case where the amount of oxygen is insufficient, the voltage value at the first inflection point obtained when the electric current is decreased is a negative value; and in the dry-up state, the voltage value at the first inflection point obtained when the electric current is decreased is a positive value. Accordingly, it is possible to determine whether the cause of the negative voltage is the insufficiency of the amount of oxygen or drying-up, based on the voltage value at the inflection point of dV/dI.

### A3. Cell voltage recovery processing

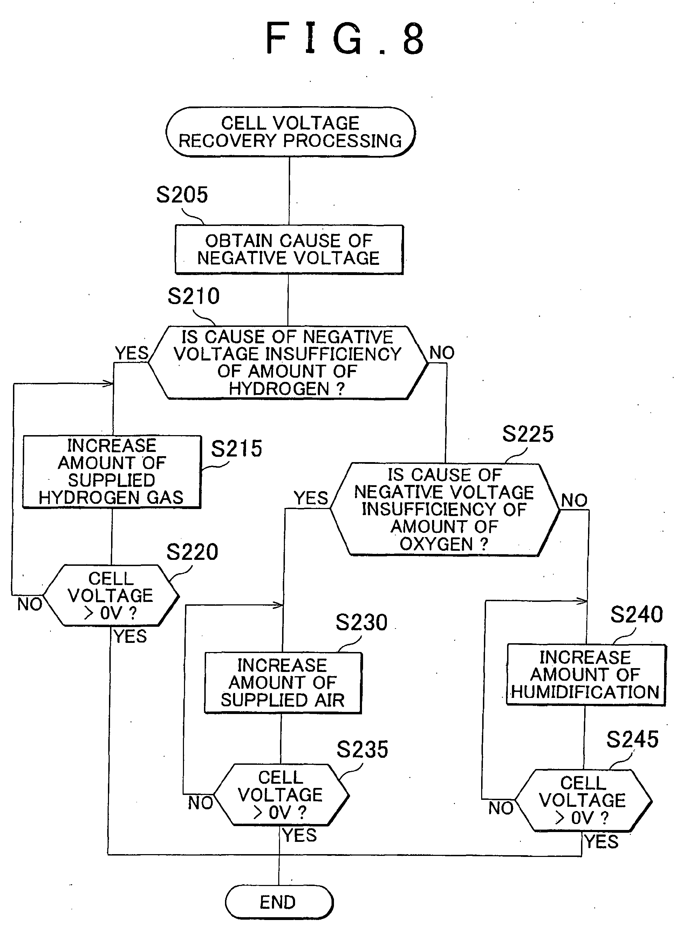

FIG 8 is a flowchart showing steps of the cell voltage recovery processing in the first embodiment. In the fuel cell system 100, when the negative voltage cause determining processing ends, the cell voltage recovery processing is started.

The negative voltage cause determining portion 91c obtains the cause of the negative voltage from the RAM 93 (step S205), and determines whether the cause of the negative voltage is the insufficiency of the amount of hydrogen (step S210). If it is determined that the cause of the negative voltage is the insufficiency of the amount of hydrogen (YES in step S210), the gas flow rate adjusting portion 91d increases the amount of hydrogen gas supplied to the fuel cell stack 10, by controlling the shutoff valve 71 and the pressure adjusting valve 72 (step S215). Then, the gas flow rate adjusting portion 91d determines whether the cell voltage of the unit cell 20 has become higher than 0 volt due to the increase in the amount of the supplied hydrogen gas (step S220). The gas flow rate adjusting portion 91d repeats the processes in steps S215 and S220 until the cell voltage becomes higher than 0 volt. If the cell voltage has become higher than 0 volt, the cell voltage recovery processing ends.

If it is determined that the cause of the negative voltage is not the insufficiency of the amount of hydrogen (NO in step S210), the negative voltage cause determining portion 91c determines whether the cause of the negative voltage is the insufficiency of the amount of oxygen (step S225). If it is determined that the cause of the negative voltage is the insufficiency of the amount of oxygen (YES in step S225), the gas flow rate adjusting portion 91d increases the amount of air supplied to the fuel cell stack 10 by controlling the rotational speed of the air compressor 65 (step S230). Then, the gas flow rate adjusting portion 91d determines whether the cell voltage of the unit cell 20, which was the negative voltage, has become a positive voltage due to the increase in the amount of supplied air (step S235). The gas flow rate adjusting portion 91d repeats the processes in steps S230 and S235 until the cell voltage becomes a positive voltage. If the cell voltage has become a positive voltage, the cell voltage recovery processing ends.

If it is determined that the cause of the negative voltage is not the insufficiency of the amount of oxygen (NO in step S225), the humidification control portion 91e increases the amount of humidification of air supplied to the fuel cell stack 10, by controlling the humidifier 66 (step S240). By executing this process, the amount of moisture inside the unit cell 20 is increased, and the unit cell 20 may be no longer in the dry-up state. Then, the humidification control portion 91 e determines whether the cell voltage of the unit cell, which was the negative voltage, has become higher than 0 volt as a result of the unit cell 20 being no longer in the dry-up state (step S245). The humidification control portion 91 e repeats the processes in steps S240 and S245 until the cell voltage becomes higher than 0 volt. If the cell voltage has become higher than 0 volt, the cell voltage recovery processing ends.

In the fuel cell system 100 that has been described, the I-V characteristic curve is obtained by measuring the voltage value while the electric current flowing in the fuel cell stack 10 is decreased to 0; and it is determined whether the cause of the negative voltage is the insufficiency of the amount of hydrogen, the insufficiency of the amount of oxygen, or drying-up, by determining whether there is the electric current value range in which dV/dI is constant in the obtained I-V characteristic curve, and determining whether the voltage at the first inflection point is a negative voltage, if there is the electric current value range in which dV/dI is constant. Accordingly, it is possible to accurately determine the cause of the negative voltage, and to accurately determine the cause even when the negative voltage is caused due to drying-up.

In addition, after the cause of the negative voltage is determined, the cell voltage recovery processing is executed to execute an appropriate process in accordance with the determined cause. Therefore, it is possible to increase the cell voltage from a negative voltage to a positive voltage in a short time period. Accordingly, it is possible to reduce the possibility that members constituting the catalytic layer deteriorate due to the negative voltage.

### B. Second embodiment

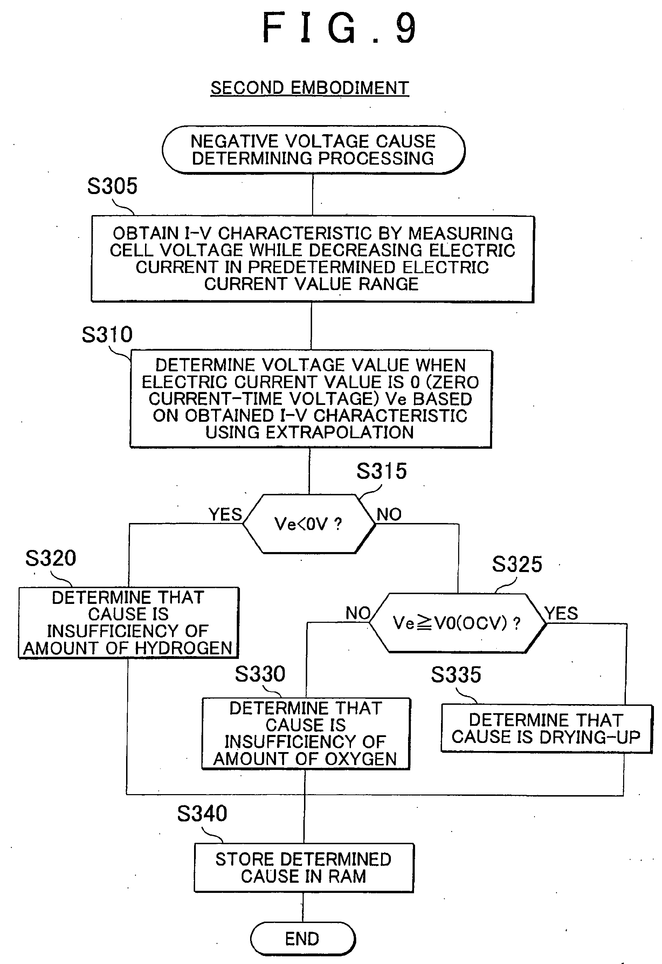

FIG 9 is a flowchart showing steps of negative voltage cause determining processing in a second embodiment of the invention. A fuel cell system in the second embodiment is different from the fuel cell system 100 in the first embodiment in a method of determining the cause of the negative voltage. The other portions of the configuration of the fuel cell system in the second embodiment are the same as those of the configuration of the fuel cell system in the first embodiment. In the negative voltage cause determining processing in the first embodiment shown in FIG. 2, the cause of the negative voltage is determined by decreasing the electric current to 0, determining whether there is the electric current value range in which dV/dI is constant, and determining whether the voltage at the first inflection point is a negative voltage. In contrast, in the second embodiment, the value of the electric current is decreased in a predetermined electric current value range, the voltage value at a time when the electric current value is 0 is determined based on the obtained I-V characteristic using extrapolation, and the cause of the negative voltage is determined based on the determined voltage value.

More specifically, as shown in FIG 9, the electric current adjusting portion 91 a decreases the value of the electric current in a predetermined electric current value range (i.e., in a range in which the electric current value is higher than 0) from the electric current value in the state in which the negative voltage is measured, and the voltage measuring portion 91 b obtains the cell voltage at each electric current value (i.e., the I-V characteristic curve), and causes the RAM 93 to store the I-V characteristic curve (step S305). At this time, the value of the electric current may be decreased in a predetermined electric current value range, for example, from the electric current value in the state in which the negative voltage is measured, to the electric current value that is 0.7 times the electric current value in the state in which the negative voltage is measured. Also, for example, a lower limit value may be preliminarily set, and the value of the electric current may be decreased to the lower limit value.

The negative voltage cause determining portion 91c determines the voltage value at a time when the electric current value is 0 (hereinafter, the voltage value may be referred to as "zero current-time voltage value"), based on the I-V characteristic obtained in step S305, using extrapolation (step S310). The method of extrapolation may be, for example, a method in which straight-line approximation is performed on the I-V characteristic obtained in step S305, and the zero current-time voltage value is determined by assigning 0 to the electric current value in the obtained straight line.

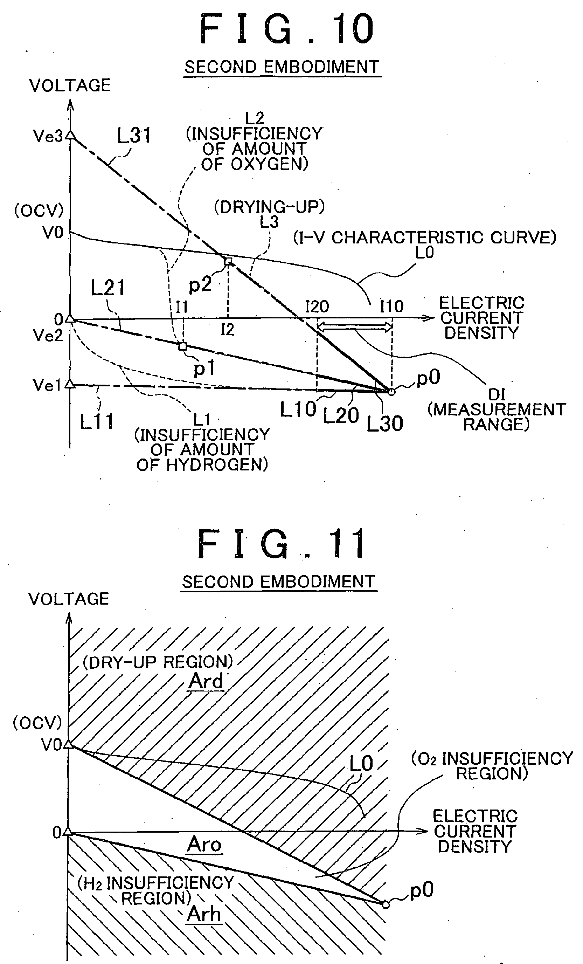

FIG 10 is an explanatory diagram showing examples of the zero current-time voltage value determined in step S310. In FIG 10, the abscissa axis is the same as the abscissa axis in FIG 3, and the ordinate axis is the same as the ordinate axis in FIG 3. Also, in FIG 10, the operating point p0 is the same as the operating point p0 in FIG 3. FIG 10 shows the I-V characteristic curve (or straight line) obtained in step S305, the straight line obtained through straight-line approximation, and the zero current-time voltage value, with regard to each cause of the negative voltage. For reference, FIG 10 also shows the curves L1 to L3 shown in FIG 3. Note that FIG 10 shows the results obtained when the value of the electric current is decreased from an electric current value I10 at the operating point p0 to an electric current value I20 (0 < I20 < I10). The electric current value I20 is higher than the electric current value I1 at the operating point p1 (the inflection point p1) and the electric current value 12 at the operating point p2 (the inflection point p2), and is preliminarily set by experiment. The range DI from the electric current value 110 to the electric current value 120 may be regarded as the predetermined positive electric current value range according to the invention.

In FIG 10, a curve L10 indicates the I-V characteristic curve obtained in step S305 in the case where the amount of hydrogen is insufficient. A straight line L20 indicates the I-V characteristic curve (i.e., the I-V characteristic straight line) obtained in step S305 in the case where the amount of oxygen is insufficient. A straight line L30 indicates the I-V characteristic curve (i.e., the I-V characteristic straight line) obtained in step S305 in the dry-up state. A straight line L11 is a straight line obtained through straight-line approximation based on a plurality of operating points in the curve L10. A straight line L21 is a straight line obtained through straight-line approximation based on a plurality of operating points in the straight line L20. A straight line L31 is a straight line obtained through straight-line approximation based on a plurality of operating points in the straight line L30.

As shown in FIG 10, in the case where the amount of hydrogen is insufficient, a zero current-time voltage Ve1 is a negative voltage. In the case where the amount of oxygen is insufficient, a zero current-time voltage Ve2 is 0 volt. In the dry-up state, a zero current-time voltage Ve3 is equal to or higher than V0 (OCV).

FIG 11 is an explanatory diagram showing a region in which the straight line obtained through straight-line approximation may exist, with regard to each cause of the negative voltage. In FIG 11, a region Arh indicates a region in which the straight line obtained through straight-line approximation may exist in the case where the cause of the negative voltage is the insufficiency of the amount of hydrogen. A region Aro indicates a region in which the straight line obtained through straight-line approximation may exist in the case where the cause of the negative voltage is the insufficiency of the amount of oxygen. A region Ard indicates a region in which the straight line obtained through straight-line approximation may exist in the case where the cause of the negative voltage is drying-up.

As shown in FIG 11, there is the region regarding each cause, in which the straight line obtained through straight-line approximation may exist. In other words, the straight line obtained through straight-line approximation may vary, because the curve (or straight line) obtained in step S305 may vary depending on, for example, the degree of insufficiency of the amount of each reaction gas, and the degree of dryness. For example, in the case where the degree of insufficiency of the amount of hydrogen is low (i.e., in the case where the amount of hydrogen is smaller than the required amount, but a certain amount of hydrogen gas is supplied), the shape of the I-V characteristic curve is close to the shape of the I-V characteristic curve L0 at the normal time. In contrast, in the case where the degree of insufficiency of the amount of hydrogen is high (i.e., in the case where almost no hydrogen gas is supplied), the shape of the I-V characteristic curve is greatly different from the shape of the I-V characteristic curve L0 at the normal time. Accordingly, the inclination of the straight line obtained through straight-line approximation based on the I-V characteristic may vary.

As shown in FIG 11, in the region Arh, the zero current-time voltage value is lower than 0 volt. In the region Aro, the zero current-time voltage value is equal to or higher than 0 volt and lower than V0 (OCV). In the region Ard, the zero current-time voltage value is equal to or higher than V0 (OCV). In the dry-up state, the membrane resistance value is large. Therefore, in an open circuit situation as well, when the unit cell 20 is in the dry-up state, the voltage value is higher than the voltage value when the unit cell 20 is not in the dry-up state.

After the process in step S310 shown in FIG 9 is executed, the negative voltage cause determining portion 91c determines whether the zero current-time voltage value Ve obtained in step S310 is lower than 0 volt (step S315). If it is determined that the zero current-time voltage value Ve is lower than 0 volt (YES in step S315), the negative voltage cause determining portion 91 c determines that the cause of the negative voltage is the insufficiency of the amount of hydrogen (step S320), and causes the RAM 93 to store the determined cause (step S340).

If it is determined that the zero current-time voltage value Ve is equal to or higher than 0 (NO in step S315), the negative voltage cause determining portion 91 c determines whether the zero current-time voltage value Ve is equal to or higher than V0 (OCV) (step S325). If it is determined that the zero current-time voltage value Ve is lower than V0 (NO in step S325), the negative voltage cause determining portion 91c determines that the cause of the negative voltage is the insufficiency of the amount of oxygen (step S330), and causes the RAM 93 to store the determined cause (step S340).

If it is determined that the zero current-time voltage value Ve is equal to or higher than V0 (YES in step S325), the negative voltage cause determining portion 91c determines that the cause of the negative voltage is drying-up (step S335), and causes the RAM 93 to store the determined cause (step S340).

The fuel cell system with the above-described configuration in the second embodiment has the same advantageous effects as those of the fuel cell system 100 in the first embodiment. In addition, because the lower limit value employed when the electric current value is decreased in step S305 is higher than 0, and higher than the electric current values at the inflection points p1 and p2, it is possible to complete the process of measuring the voltage value in a short time period, as compared to the case where the lower limit value is 0. Accordingly, the cause of the negative voltage is determined in a shorter time period, and thus, the negative voltage recovery processing is executed more quickly after the cell voltage becomes a negative voltage. Thus, it is possible to reduce the possibility that the catalyst deteriorates.

### C. Third embodiment

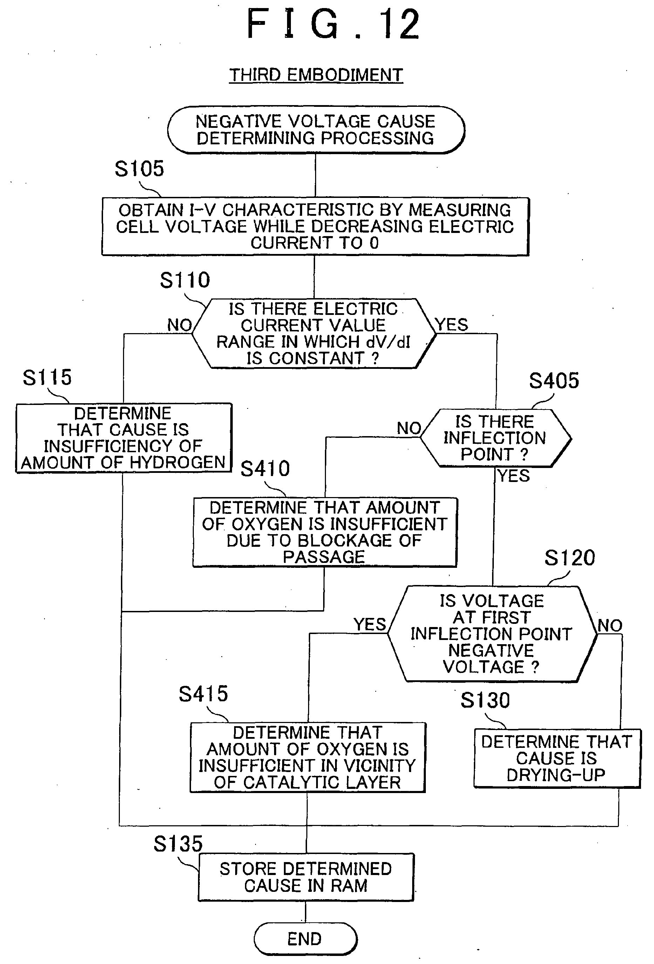

FIG 12 is a flowchart showing steps of negative voltage cause determining processing in a third embodiment. A fuel cell system in the third embodiment is different from the fuel cell system 100 in the first embodiment in that in the case where the cause of the negative voltage is the insufficiency of the amount of oxygen, it is determined whether the amount of oxygen is insufficient due to the blockage of the passage (i.e., the blockage of the oxidant gas supply passage 87) (in other words, no air is delivered to the cathode-side catalytic layer due to the blockage of the passage), or the amount of oxygen is insufficient in the vicinity of the catalytic layer (in other words, air is delivered to the cathode-side catalytic layer, but the amount of supplied air is smaller than the required amount), and in that a measure among different measures is taken according to the cause of the insufficiency of the amount of oxygen. The other portions of the configuration of the fuel cell system in the third embodiment are the same as those of the configuration of the fuel cell system 100 in the first embodiment.

### C1. Negative voltage cause determining processing

The negative voltage cause determining processing in the third embodiment is different from the negative voltage cause determining processing shown in FIG 2 in that steps S405 and S410 are added and executed, and step S415 is executed instead of step S125. The other processes of the negative voltage cause determining processing in the third embodiment are the same as those of the negative voltage cause determining processing in the first embodiment. More specifically, if it is determined that there is the range in which dV/dI is constant (YES in step S110), the negative voltage cause determining portion 91c determines whether there is an inflection point in the I-V characteristic curve obtained in step S105 (step S405).

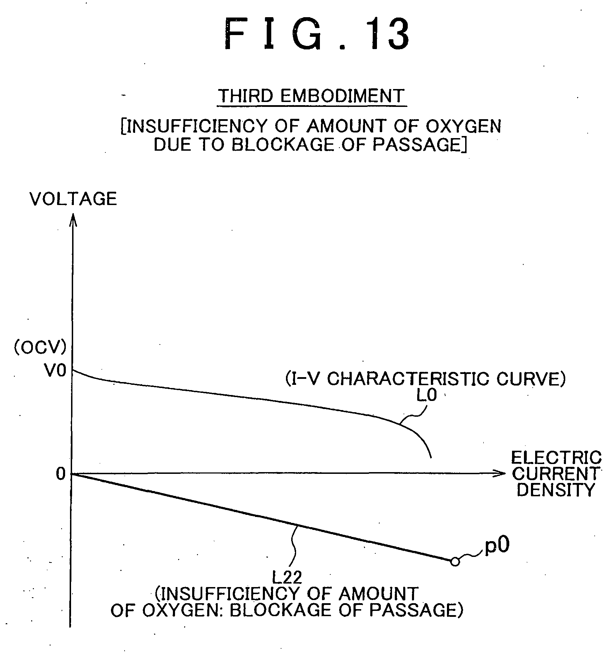

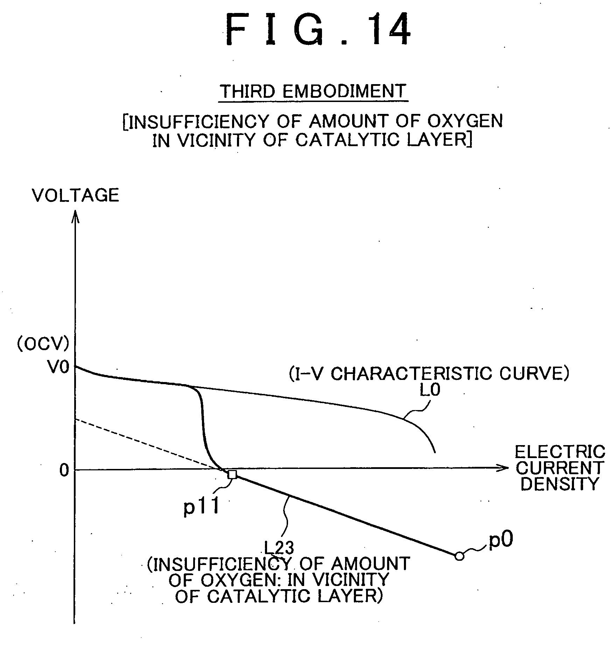

FIG 13 is an explanatory diagram showing the I-V characteristic curve obtained in step S105 in the case where the amount of oxygen is insufficient due to the blockage of the passage. FIG 14 is an explanatory diagram showing the I-V characteristic curve obtained in step S105 in the case where the amount of oxygen is insufficient in the vicinity of the catalytic layer. In each of FIG 13 and FIG 14, the abscissa axis is the same as the abscissa axis in FIG 3, and the ordinate axis is the same as the ordinate axis in FIG 3. Also, in each of FIG 13 and FIG 14, the operating point p0 is the same as the operating point p0 in FIG 3. In FIG 13, a straight line L22 indicates the I-V characteristic curve obtained in step S105 in the case where the amount of oxygen is insufficient due to the blockage of the passage. In FIG. 14, a curve L23 indicates the I-V characteristic curve obtained in step S105 in the case where the amount of oxygen is insufficient in the vicinity of the catalytic layer.

As shown in FIG 13, the straight line L22, which is obtained in step S105 in the case where the amount of oxygen is insufficient due to the blockage of the passage, is a straight line connecting the operating point p0 and an operating point (original point) at which the electric current value is 0 and the voltage value is 0, as in the case of the straight line L2a shown in the lower right graph in FIG 6. Because no oxygen is supplied to the cathode-side catalytic layer of the unit cell 20, the amount of oxygen remains insufficient even when the electric current value is close to 0. Thus, the voltage increases in proportion to the decrease in the electric current until the electric current value becomes 0. Therefore, there is no inflection point in the straight line L22.

As shown in FIG 14, the curve L23, which is obtained in step S105 in the case where the amount of oxygen is insufficient in the vicinity of the catalytic layer, extends linearly in a range from the operating point p0 to an inflection point p11, extends toward the curve L0 in a range from the inflection point p11, and coincides with the curve L0 in a range where the electric current value is small, as the curve L2 shown in FIG 3 and FIG 6.

If it is determined that there is no inflection point in step S405 shown in FIG 12 (NO in step S405), the negative voltage cause determining portion 91c determines that the cause of the negative voltage is the insufficiency of the amount of oxygen due to the blockage of the passage (step S410). If it is determined that there is the inflection point in step S405 (YES in step S405), the negative voltage cause determining portion 91c execute the process in the above-described step S120. Then, if it is determined that the voltage at the first inflection point is a negative voltage (YES in step S120), the negative voltage cause determining portion 91 c determines that the cause of the negative voltage is the insufficiency of the amount of oxygen in the vicinity of the catalytic layer (step S415). In contrast, if it is determined that the voltage at the first inflection point is not a negative voltage (NO in step S120), the negative voltage cause determining portion 91c determines that the cause of the negative voltage is drying-up (step S130).

### C2. Cell voltage recovery processing

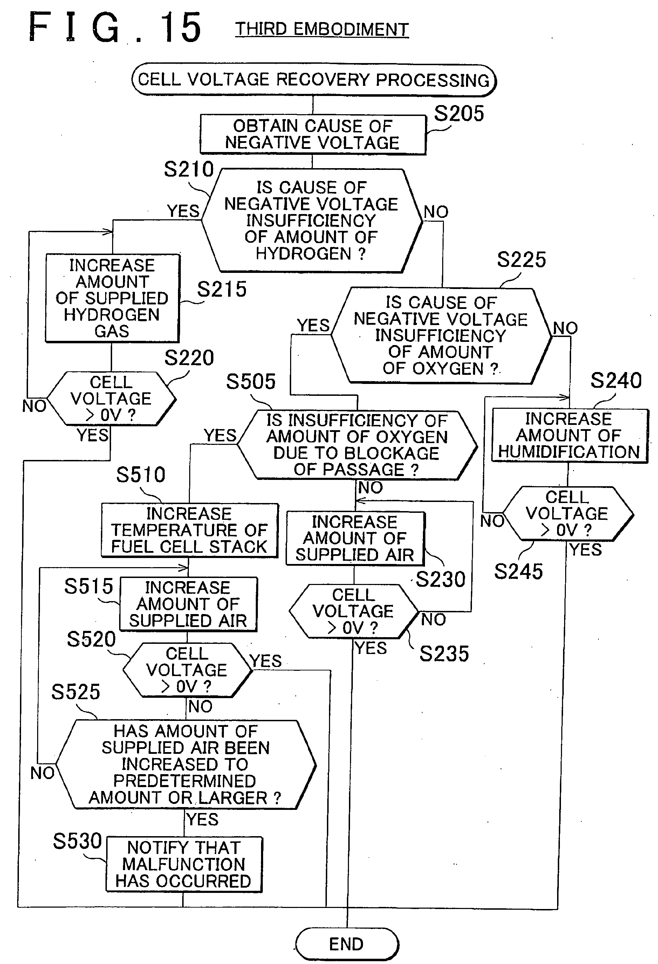

FIG. 15 is a flowchart showing steps of cell voltage recovery processing in the third embodiment. The cell voltage recovery processing in the third embodiment is different from the cell voltage recovery processing shown in FIG 8 in that steps S505, S510, S515, S520, S525, and S530 are added and executed. The other processes in the cell voltage recovery processing in the third embodiment are the same as those in the cell voltage recovery processing in the first embodiment. More specifically, if it is determined that the cause of the negative voltage is the insufficiency of the amount of oxygen in step S225 (YES in step S225), the negative voltage cause determining portion 91c determines whether the amount of oxygen is insufficient due to the blockage of the passage (step S505).

If it is determined that the insufficiency of the amount of oxygen is not due to the blockage of the passage, that is, if it is determined that the amount of oxygen is insufficient in the vicinity of the catalytic layer (NO in step S505), the amount of supplied air is increased until the cell voltage becomes higher than 0 volt (steps S230 and S235).

In contrast, if it is determined that the amount of oxygen is insufficient due to the blockage of the passage (YES in step S505), the stack temperature adjusting portion 91f increases the temperature of the fuel cell stack 10 to a predetermined temperature (for example, 0 °C) or higher (step S510). Then, the gas flow rate adjusting portion 91d increases the amount of air supplied to the fuel cell stack 10 (step S515). The gas flow rate adjusting portion 91d determines whether the cell voltage has become higher than 0 volt (step S520). If the cell voltage has become higher than 0 volt, the cell voltage recovery processing ends. If it is determined that the cell voltage is equal to or lower than 0 volt (NO in step S520), the gas flow rate adjusting portion 91 d determines whether the amount of supplied air has been increased to a predetermined amount or larger (step S525). If it is determined that the amount of supplied air has not been increased to the predetermined amount or larger (NO in step S525), the gas flow rate adjusting portion 91d executes the processes in the above-described steps S515 to S525. In contrast, if it is determined that the amount of supplied air has been increased to the predetermined amount or larger (YES in step S525), the malfunction occurrence notifying portion 91g notifies a manager that a malfunction has occurred, by causing the operation panel (not shown) to indicate that a malfunction has occurred (step S530).

If the amount of oxygen is insufficient due to the blockage of the passage, the amount of air supplied to the fuel cell stack 10 is increased after increasing the temperature of the fuel cell stack 10, for the following reason. If water generated due to electric power generation is accumulated in the oxidant gas supply passage, and the passage is blocked due to the accumulated water, the temperature is increased to increase the saturated vapor pressure. Accordingly, the accumulated water is transformed to vapor that is easily discharged. Therefore, when the amount of supplied air is increased thereafter, the accumulated water (vapor) is discharged using the flow of air, and in addition, the amount of air becomes sufficient.

If the cell voltage remains equal to or lower than 0 volt although the temperature of the fuel cell stack 10 has been increased and the amount of supplied air has been increased to the predetermined amount or larger, there is a high possibility that the passage is blocked for a reason other than the accumulation of the generated water. In this case, the manager needs to determine the cause of the blockage, and to perform maintenance. Therefore, the fuel cell system in the third embodiment is configured to notify the manager that a malfunction has occurred.

The fuel cell system with the above-described configuration in the third embodiment has the same advantageous effects as those of the fuel cell system 100 in the first embodiment. In addition, in the fuel cell system in the third embodiment, it is determined whether the amount of oxygen is insufficient due to the blockage of the passage, or the amount of oxygen is insufficient in the vicinity of the catalytic layer. Therefore, it is possible to select and execute an appropriate process in accordance with the cause of the insufficiency of the amount of oxygen, in the cell voltage recovery processing.

If the amount of oxygen is insufficient due to the blockage of the passage, the amount of supplied air is increased after the temperature of the fuel cell stack 10 is increased. Therefore, if the passage is blocked because the water generated due to the electric power generation is accumulated in the passage, the accumulated water is discharged, and the amount of oxygen quickly becomes sufficient.

In the case where the amount of oxygen is insufficient due to the blockage of the passage, if the cell voltage remains equal to or lower than 0 volt although the amount of supplied air has been increased to the predetermined amount or larger after increasing the temperature of the fuel cell stack 10, the manager is notified that a malfunction has occurred. Therefore, the manager determines the cause of the blockage of the passage, and performs maintenance, based on the notification. Accordingly, even when the blockage of the passage is not due to the generated water, maintenance is quickly performed, and the amount of oxygen quickly becomes sufficient.

### D. Fourth embodiment

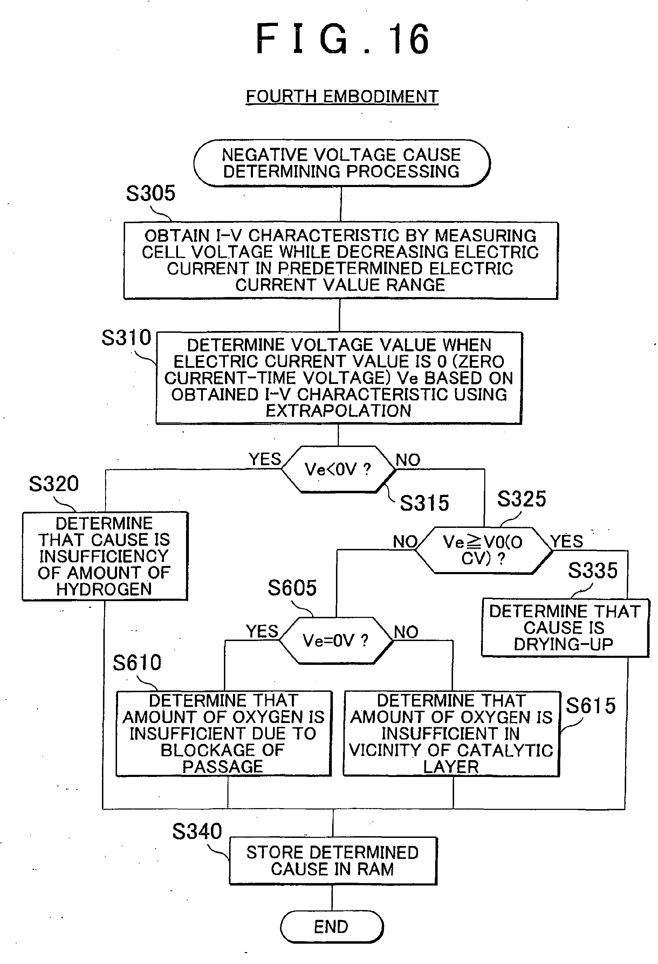

FIG. 16 is a flowchart showing steps of negative voltage cause determining processing in a fourth embodiment of the invention. A fuel cell system in the fourth embodiment is different from the fuel cell system 100 in the first embodiment in that if the cause of the negative voltage is the insufficiency of the amount of oxygen, it is determined whether the amount of oxygen is insufficient due to the blockage of the passage, or the amount of oxygen is insufficient in the vicinity of the catalytic layer, and in that a measure among different measures is taken in accordance with the cause of the insufficiency of the amount of oxygen. The other portions of the configuration of the fuel cell system in the fourth embodiment are the same as those of the configuration of the fuel cell system 100 in the first embodiment. Further, the fuel cell system in the fourth embodiment is different from the fuel cell system in the third embodiment, in a method of determining whether the amount of oxygen is insufficient due to the blockage of the passage, or the amount of oxygen is insufficient in the vicinity of the catalytic layer. The other portions of the configuration of the fuel cell system in the fourth embodiment are the same as those of the configuration of the fuel cell system in the third embodiment. In the fuel cell system in the fourth embodiment, the value of the electric current is decreased in a predetermined electric current value range, and the zero current-time voltage value is determined based on the obtained I-V characteristic using extrapolation, as in the second embodiment. Then, the cause of the insufficiency of the amount of oxygen is determined based on the zero current-time voltage value.

The negative voltage cause determining processing in the fourth embodiment shown in FIG 16 is different from the negative voltage cause determining processing in the second embodiment shown in FIG 9 in that steps S605, S610, and S615 are added and executed instead of step S330. The other processes in the negative voltage cause determining processing in the fourth embodiment are the same as those in the negative voltage cause determining processing in the second embodiment.

In step S325, if it is determined that the zero current-time voltage value Ve is lower than V0 (OCV) (NO in step S325), the negative voltage cause determining portion 91c determines whether the zero current-time voltage value Ve is 0 volt (step S605). If it is determined that the zero current-time voltage value Ve is 0 volt, the negative voltage cause determining portion 91 c determines that the amount of oxygen is insufficient due to the blockage of the passage (step S610), and if it is determined that the zero current-time voltage value Ve is not 0 volt (that is, the zero current-time voltage value Ve is higher than 0 volt and lower than V0 (OCV)), the negative voltage cause determining portion 91c determines that the amount of oxygen is insufficient in the vicinity of the catalytic layer (S615).

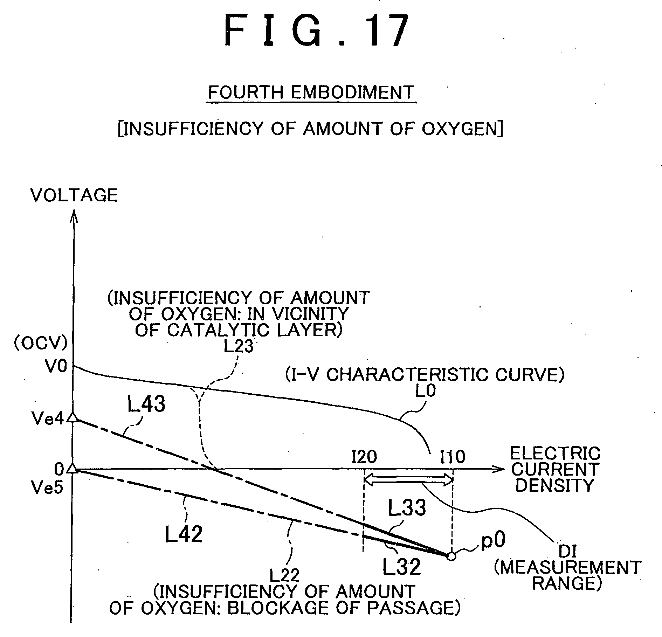

FIG 17 is an explanatory diagram showing examples of the zero current-time voltage value obtained in step S310 in the fourth embodiment. In FIG 17, the abscissa axis and the ordinate axis are the same as the abscissa axis and the ordinate axis in FIG 10. Also, the operating point p0 is the same as the operating point p0 in FIG 3. In FIG 17, for reference, the straight line L22 shown in FIG 13 and the curve L23 shown in FIG 14 are shown in the form of dash lines (note that the straight line L22 coincides with a straight line L42 described later). In FIG 17, a straight line L32 indicates the I-V straight line obtained in step S305 in the case where the amount of oxygen is insufficient due to the blockage of the passage. A straight line L33 indicates the I-V straight line obtained in step S305 in the case where the amount of oxygen is insufficient in the vicinity of the catalytic layer. Each of the straight lines L32 and L33 indicates the result obtained when the value of the electric current is decreased from the electric current value I10 at the operating point p0 to the electric current value 120 (0 < 120 < I10) in step S305.

In FIG 17, the straight line L42 is a straight line obtained through straight-line approximation based on a plurality of operating points in the straight line L32. In the straight line L42, a voltage value Ve5 at the time when the electric current value is 0 (i.e., zero current-time voltage value Ve5) is 0 volt. Thus, if the amount of oxygen is insufficient due to the blockage of the passage, the zero current-time voltage value Ve is 0 volt, as described with reference to FIG 13.

In FIG 17, the straight line L43 is a straight line obtained through straight-line approximation based on a plurality of operating points in the straight line L33. In the straight line L43, a voltage value Ve4 at the time when the electric current value is 0 (i.e., zero current-time voltage value Ve4) is higher than 0 volt and lower than V0 (OCV). In the case where the amount of oxygen is insufficient in the vicinity of the catalytic layer, oxygen is supplied to the cathode-side catalytic layer although the amount of supplied oxygen is smaller than the required amount. Therefore, in the case where the amount of oxygen is insufficient in the vicinity of the catalytic layer, the voltage values obtained when the value of the electric current is decreased are higher than the voltage values obtained when the value of the electric current is decreased in the case where no oxygen is supplied to the cathode-side catalytic layer. Accordingly, the zero current-time voltage value Ve4 in the straight line L43 is higher than the zero current-time voltage value Ve5 in the straight line L42. Also, because the amount of oxygen is insufficient, the zero current-time voltage value Ve is lower than V0 (OCV). Thus, it is possible to determine whether the amount of oxygen is insufficient due to the blockage of the passage, or the amount of oxygen is insufficient in the vicinity of the catalytic layer, by determining whether the zero current-time voltage Ve is 0 volt, as in step S605.

After the process in step S610 or S615 is executed, the process in step S340 (i.e., the process of causing the RAM 93 to store the determined cause) is executed, and the negative voltage cause determining processing ends. The cell voltage recovery processing in the fourth embodiment is the same as the cell voltage recovery processing in the third embodiment in FIG 15.

The fuel cell system with the above-described configuration in the fourth embodiment has the same advantageous effects as those of the fuel cell system 100 in the first embodiment. In addition, in the fuel cell system in the fourth embodiment, it is determined whether the amount of oxygen is insufficient due to the blockage of the passage, or the amount of oxygen is insufficient in the vicinity of the catalytic layer, and therefore, it is possible to execute an appropriate process in accordance with the cause of the insufficiency of the amount of oxygen in the cell voltage recovery processing. Also, because the lower limit value employed when the electric current value is decreased in step S305 is higher than 0, and higher than the electric current values at the inflection points p1 and p2, it is possible to complete the process of measuring the voltage value in a short time period, as compared to the case where the lower limit value is 0. Accordingly, the cause of the negative voltage is determined in a shorter time period, and thus, the negative voltage recovery processing is executed more quickly after the cell voltage becomes a negative voltage. Thus, it is possible to reduce the possibility that the catalyst deteriorates.

### E. Modified example

The invention is not limited to the above-described embodiments. Thus, the invention may be implemented in various manners without departing from the scope of the invention. For example, modifications described below may be made.

### E1. First modified example

In each of the first and third embodiments, in step S105, the value of the electric current is decreased from the electric current value in the state in which the negative voltage is measured, to the electric current value of 0. However, the invention is not limited to this configuration. For example, the configuration may be such that the value of the electric current is decreased from the electric current value in the state in which the negative voltage is measured; each time the voltage value is obtained, it is determined whether there is an inflection point; and if the inflection point is caused, the decrease of the electric current is stopped, and the process in step S105 ends. In this configuration, when the cause of the negative voltage is the insufficiency of the amount of oxygen or drying-up, it is not necessary to decrease the electric current value up to 0, and therefore, it is possible to decrease the time period required to execute the negative voltage cause determining processing.

### E2. Second modified example

In each embodiment, in the cell voltage recovery processing, if the cause of the negative voltage is the insufficiency of the amount of hydrogen, the amount of supplied hydrogen gas is increased. In addition, the fuel cell stack 10 may be electrically separated from the load L. Also, at this time, electric power may be supplied to the load L from the secondary battery 52. In this configuration, the fuel cell stack 10 can be placed in the OCV state. Therefore, when the amount of supplied hydrogen gas is increased, the anode-side catalytic layer is exposed to a sufficient amount of hydrogen gas, and thus, the catalyst, which has been inactivated, is brought to the active state. That is, when the amount of supplied hydrogen gas is increased, it is possible to remove the oxide of the catalyst such as platinum, which has been generated in the anode-side catalytic layer due to the insufficiency of the amount of hydrogen. Also, because electric power is supplied from the secondary battery 52 to the load L, the cell voltage recovery processing is executed without stopping the electric vehicle.

### E3. Third modified example

In the cell voltage recovery processing in the third embodiment, if the cause of the negative voltage is the insufficiency of the amount of oxygen in the vicinity of the catalytic layer, the amount of supplied air is increased in step S230. In addition to increasing the amount of supplied air, the temperature of the fuel cell stack 10 may be increased. Similarly, in the first embodiment as well, if the cause of the negative voltage is the insufficiency of the amount of oxygen, the temperature of the fuel cell stack 10 may be increased, in addition to increasing the amount of supplied air (step S230). In the configuration, in the case where the amount of oxygen is insufficient in the vicinity of the catalytic layer due to the accumulation of the generated water in the vicinity of the catalytic layer, the generated water is removed, and the amount of oxygen becomes sufficient.

### E4. Fourth modified example

In each embodiment, the stack temperature adjusting portion 91 f adjusts the temperature of the fuel cell stack 10, by controlling the second circulation pump 31 to adjust the flow rate of the cooling medium. However, the invention is not limited to this configuration. For example, the configuration may be such that a heater is provided in the cooling medium supply passage 84 or the cooling medium discharge passage 85, and the temperature of the fuel cell stack 10 is adjusted by increasing the temperature of the cooling medium using the heater. Also, the configuration may be such that a heater is provided to directly heat the unit cells 20, and the temperature of the fuel cell stack 10 is adjusted using the heater.

### E5. Fifth modified example

In each embodiment, the malfunction occurrence notifying portion 91g causes the operation penal (not shown) to indicate that a malfunction has occurred. Instead of, or in addition to the indication in the operation panel, notification may be provided using sound such as buzzer, or a lamp may be lit or may be caused to flash to notify that a malfunction has occurred. Also, instead of notifying that a malfunction has occurred, a log indicating that a malfunction has occurred may be stored in the RAM 93. In this configuration as well, the manager is aware that a malfunction has occurred by seeing the log stored in the RAM 93. Thus, the manger can determine the cause of the negative voltage, and can perform, for example, maintenance.

### E6. Sixth modified example

In each embodiment, it is determined whether the cause of the negative voltage is the insufficiency of the amount of hydrogen, the insufficiency of the amount of oxygen, or drying-up. However, the invention is not limited to this configuration. For example, it may be determined whether the cause of the negative voltage is the insufficiency of the amount of hydrogen, or a cause other than the insufficiency of the amount of hydrogen. More specifically, for example, in the negative voltage cause determining processing in the first embodiment, the processes in step S120 and subsequent steps may be omitted. In this configuration as well, it is possible to determine whether the cause of the negative voltage is the insufficiency of the amount of hydrogen, or a cause other than the insufficiency of the amount of hydrogen. Therefore, if the cause of the negative voltage is the insufficiency of the amount of hydrogen, it is possible to take an appropriate measure (for example, it is possible to execute the processes in steps S215 and S220 in FIG 8).

### E7. Seventh modified example

In each embodiment, the fuel cell system is provided in an electric vehicle. However, the fuel cell system according to the invention may be employed in various movable bodies such as a hybrid vehicle, a ship, and a robot, instead of the electric vehicle. Also, the fuel cell stack 10 may be used as a stationary power source, and the fuel cell system may be employed in architectural structures such as a building and a house.

### E8. Eighth modified example

In each embodiment, a portion of the configuration implemented by software may be replaced by hardware. On the other hand, a portion of the configuration implemented by hardware may be replaced by software.

## Claims

1. A fuel cell system, comprising:
a fuel cell (20);
a voltage measuring portion (91b) that measures a voltage of the fuel cell (20);
an electric current adjusting portion (91a) that adjusts an electric current flowing in the fuel cell (20);
an electric current-voltage characteristic information obtaining portion (91 b) that controls the electric current adjusting portion (91 a) to change the electric current, and obtains electric current-voltage characteristic information that is information indicating a correspondence relation between an electric current value and a voltage value measured by the voltage measuring portion (91b); and
a negative voltage cause determining portion (91c) that determines, if the voltage of the fuel cell (20) is a negative voltage, a cause of the negative voltage of the fuel cell (20), based on the obtained electric current-voltage characteristic information,
wherein,
in the fuel cell (20), a fuel gas containing hydrogen and an oxidant gas containing oxygen are used as reaction gases;
**characterized in that**,
when the electric current-voltage characteristic information is obtained, the electric current-voltage characteristic information obtaining portion (91b) obtains the voltage value while changing the electric current in a range in which the electric current is higher than 0;
the negative voltage cause determining portion (91c) determines a zero current-time voltage value that is the voltage value at a time when the electric current is 0, based on the obtained electric current-voltage characteristic information, using extrapolation;
if the zero current-time voltage value is lower than 0 volt, the negative voltage cause determining portion (91c) determines that the cause is insufficiency of an amount of hydrogen;
if the zero current-time voltage value is equal to or higher than 0 volt and lower than an open circuit voltage of the fuel cell (20) at a normal time, the negative voltage cause determining portion (91c) determines that the cause is insufficiency of an amount of oxygen; and
if the zero current-time voltage value is equal to or higher than the open circuit voltage, the negative voltage cause determining portion (91c) determines that the cause is drying-up.

2. The fuel cell system according to claim 1, wherein
the fuel cell (20) includes a catalytic layer, and an oxidant gas supply passage through which the oxidant gas is supplied to the catalytic layer;
if the zero current-time voltage value is 0 volt, the negative voltage cause determining portion (91c) determines that the cause is the insufficiency of the amount of oxygen due to blockage of the oxidant gas supply passage; and
if the zero current-time voltage value is higher than 0 volt and lower than the open circuit voltage, the negative voltage cause determining portion (91c) determines that the cause is the insufficiency of the amount of oxygen in a vicinity of the catalytic layer.

3. The fuel cell system according to claim 1 or 2, wherein
a lower limit value in the predetermined positive electric current value range is higher than the electric current value at an inflection point of dV/dI in a case where the cause is the insufficiency of the amount of oxygen or the drying-up, the dV/dI indicating a change in the voltage value with respect to a change in the electric current value.

4. A fuel cell system, comprising:
a fuel cell (20);
a voltage measuring portion (91b) that measures a voltage of the fuel cell (20);
an electric current adjusting portion (91a) that adjusts an electric current flowing in the fuel cell (20);
an electric current-voltage characteristic information obtaining portion (91 b) that controls the electric current adjusting portion (91a) to change the electric current, and obtains electric current-voltage characteristic information that is information indicating a correspondence relation between an electric current value and a voltage value measured by the voltage measuring portion (91 b); and
a negative voltage cause determining portion (91c) that determines, if the voltage of the fuel cell (20) is a negative voltage, a cause of the negative voltage of the fuel cell (20), based on the obtained electric current-voltage characteristic information, wherein,
in the fuel cell (20), a fuel gas containing hydrogen and an oxidant gas containing oxygen are used as reaction gases;
**characterized in that**
the negative voltage cause determining portion (91c) determines dV/dI that indicates a change in the voltage value with respect to a change in the electric current value, based on the electric current-voltage characteristic information;
if there is not an electric current value range in which the dV/dI is constant, the negative voltage cause determining portion (91c) determines that the cause is insufficiency of an amount of hydrogen;
if there is the electric current value range in which the dV/dI is constant and the voltage value at an inflection point of the dV/dI is lower than 0 volt, the negative voltage cause determining portion (91c) determines that the cause is insufficiency of an amount of oxygen; and
if there is the electric current value range in which the dV/dI is constant and the voltage value at the inflection point is equal to or higher than 0 volt, the negative voltage cause determining portion (91c) determines that the cause is drying-up.

5. A fuel cell system, comprising:
a fuel cell (20);
a voltage measuring portion (91 b) that measures a voltage of the fuel cell (20);
an electric current adjusting portion (91a) that adjusts an electric current flowing in the fuel cell (20);
an electric current-voltage characteristic information obtaining portion (91b) that controls the electric current adjusting portion (91a) to change the electric current, and obtains electric current-voltage characteristic information that is information indicating a correspondence relation between an electric current value and a voltage value measured by the voltage measuring portion (91 b); and
a negative voltage cause determining portion (91c) that determines, if the voltage of the fuel cell (20) is a negative voltage, a cause of the negative voltage of the fuel cell (20), based on the obtained electric current-voltage characteristic information, wherein,
in the fuel cell (20), a fuel gas containing hydrogen and an oxidant gas containing oxygen are used as reaction gases;
the fuel cell (20) includes a catalytic layer, and an oxidant gas supply passage through which the oxidant gas is supplied to the catalytic layer;
**characterized in that**
the negative voltage cause determining portion (91c) determines dV/dI that indicates a change in the voltage value with respect to a change in the electric current value, based on the electric current-voltage characteristic information;
if there is not an electric current value range in which the dV/dI is constant, the negative voltage cause determining portion (91c) determines that the cause is insufficiency of an amount of hydrogen;
if there is the electric current value range in which the dV/dI is constant and there is not an inflection point of the dV/dI, the negative voltage cause determining portion (91c) determines that the cause is insufficiency of an amount of oxygen due to blockage of the oxidant gas supply passage; and
if there is the electric current value range in which the dV/dI is constant and the voltage value at the inflection point of the dV/dI is lower than 0 volt, the negative voltage cause determining portion (91 c) determines that the cause is the insufficiency of the amount of oxygen in a vicinity of the catalytic layer.

6. The fuel cell system according to claim 5, wherein
if there is not an electric current value range in which the dV/dI is constant, the negative voltage cause determining portion (91c) determines that the cause is insufficiency of an amount of hydrogen;
if there is the electric current value range in which the dV/dI is constant and there is not an inflection point of the dV/dI, the negative voltage cause determining portion (91c) determines that the cause is insufficiency of an amount of oxygen due to blockage of the oxidant gas supply passage;
if there is the electric current value range in which the dV/dI is constant and the voltage value at the inflection point of the dV/dI is lower than 0 volt, the negative voltage cause determining portion (91c) determines that the cause is the insufficiency of the amount of oxygen in a vicinity of the catalytic layer; and
if there is the electric current value range in which the dV/dI is constant and the voltage value at the inflection point is equal to or higher than 0 volt, the negative voltage cause determining portion (91 c) determines that the cause is drying-up.

7. The fuel cell system according to claim 2, 5, or 6, further comprising:
a temperature adjusting portion that adjusts a temperature of the fuel cell (20) to 0°C or higher, if it is determined that the cause is the insufficiency of the amount of oxygen due to the blockage of the oxidant gas supply passage; and
an oxidant gas supply portion (91d, 65) that increases an amount of the oxidant gas supplied to the fuel cell (20), if it has been determined that the cause is the insufficiency of the amount of oxygen due to the blockage of the oxidant gas supply passage and the temperature of the fuel cell (20) has been adjusted to 0°C or higher.

8. The fuel cell system according to claim 7, further comprising
a malfunction detecting portion (91g) that detects that a malfunction has occurred in the fuel cell system, if the voltage value is a negative voltage value after the amount of the supplied oxidant gas is increased by the oxidant gas supply portion (91d, 65).

9. The fuel cell system according to any one of claims 1 to 6, further comprising:
an oxidant gas supply portion (91d, 65) that increases an amount of the oxidant gas supplied to the fuel cell (20), if it is determined that the cause is the insufficiency of the amount of oxygen;
a fuel gas supply portion (91d, 71, 72) that increases an amount of the fuel gas supplied to the fuel cell (20), if it is determined that the cause is the insufficiency of the amount of hydrogen; and
a humidification portion (91 e, 66) that humidifies the fuel cell (20), if it is determined that the cause is the drying-up.

10. A method of determining a cause of a negative voltage of a fuel cell, comprising:
obtaining an electric current-voltage characteristic information that is information indicating a correspondence relation between an electric current value and a voltage value, by changing an electric current flowing in the fuel cell (20), and measuring a voltage of the fuel cell (20); and
determining the cause of the negative voltage of the fuel cell (20), based on the obtained electric current-voltage characteristic information, wherein,
in the fuel cell (20), a fuel gas containing hydrogen and an oxidant gas containing oxygen are used as reaction gases;
**characterized in that**,
when the electric current-voltage characteristic information is obtained, the voltage value is obtained while changing the electric current in a range in which the electric current is higher than 0;
a zero current-time voltage value is determined that is the voltage value at a time when the electric current is 0, based on the obtained electric current-voltage characteristic information, using extrapolation;
if the zero current-time voltage value is lower than 0 volt, insufficiency of an amount of hydrogen is determined as the cause of the negative voltage;
if the zero current-time voltage value is equal to or higher than 0 volt and lower than an open circuit voltage of the fuel cell (20) at a normal time, insufficiency of an amount of oxygen is determined as the cause of the negative voltage; and
if the zero current-time voltage value is equal to or higher than the open circuit voltage, drying-up is determined as the cause of the negative voltage.

11. A method of determining a cause of a negative voltage of a fuel cell, comprising:
obtaining an electric current-voltage characteristic information that is information indicating a correspondence relation between an electric current value and a voltage value, by changing an electric current flowing in the fuel cell (20), and measuring a voltage of the fuel cell (20); and
determining the cause of the negative voltage of the fuel cell (20), based on the obtained electric current-voltage characteristic information, wherein,
in the fuel cell (20), a fuel gas containing hydrogen and an oxidant gas containing oxygen are used as reaction gases;
**characterized in that**
dV/dI, indicating a change in the voltage value with respect to a change in the electric current value, is determined based on the electric current-voltage characteristic information;
if there is not an electric current value range in which the dV/dI is constant, insufficiency of an amount of hydrogen is determined as the cause of the negative voltage;
if there is the electric current value range in which the dV/dI is constant and the voltage value at an inflection point of the dV/dI is lower than 0 volt, insufficiency of an amount of oxygen is determined as the cause of the negative voltage; and
if there is the electric current value range in which the dV/dI is constant and the voltage value at the inflection point is equal to or higher than 0 volt, drying-up is determined as the cause of the negative voltage.

12. A method of determining a cause of a negative voltage of a fuel cell, comprising:
obtaining an electric current-voltage characteristic information that is information indicating a correspondence relation between an electric current value and a voltage value, by changing an electric current flowing in the fuel cell (20), and measuring a voltage of the fuel cell (20); and
determining the cause of the negative voltage of the fuel cell (20), based on the obtained electric current-voltage characteristic information, wherein,
in the fuel cell (20), a fuel gas containing hydrogen and an oxidant gas containing oxygen are used as reaction gases; and
the fuel cell (20) includes a catalytic layer, and an oxidant gas supply passage through which the oxidant gas is supplied to the catalytic layer;
**characterized in that**
dV/dI, indicating a change in the voltage value with respect to a change in the electric current value, is determined based on the electric current-voltage characteristic information;
if there is not an electric current value range in which the dV/dI is constant, insufficiency of an amount of hydrogen is determined as the cause of the negative voltage;
if there is the electric current value range in which the dV/dI is constant and there is not an inflection point of the dV/dI, insufficiency of an amount of oxygen due to blockage of the oxidant gas supply passage is determined as the cause of the negative voltage; and
if there is the electric current value range in which the dV/dI is constant and the voltage value at the inflection point of the dV/dI is lower than 0 volt, insufficiency of the amount of oxygen in a vicinity of the catalytic layer is determined as the cause of the negative voltage.

13. The method of determining a cause of a negative voltage of a fuel cell according to claim 12, wherein,
if there is not an electric current value range in which the dV/dI is constant, insufficiency of an amount of hydrogen is determined as the cause of the negative voltage;
if there is the electric current value range in which the dV/dI is constant and there is not an inflection point of the dV/dI, insufficiency of an amount of oxygen due to blockage of the oxidant gas supply passage is determined as the cause of the negative voltage;
if there is the electric current value range in which the dV/dI is constant and the voltage value at the inflection point of the dV/dI is lower than 0 volt, the insufficiency of the amount of oxygen in a vicinity of the catalytic layer is determined as the cause of the negative voltage; and
if there is the electric current value range in which the dV/dI is constant and the voltage value at the inflection point is equal to or higher than 0 volt, drying-up is determined as the cause of the negative voltage.

## Patentansprüche

1. Brennstoffzellensystem, aufweisend:
eine Brennstoffzelle (20);
einen Spannungsmessabschnitt (91b), der eine Spannung der Brennstoffzelle (20) misst;
einen Stromeinstellabschnitt (91a), der einen Strom einstellt, der in der Brennstoffzelle (20) fließt;
einen Strom-Spannungskennlinieninformationserhalteabschnitt (91b), der den Stromeinstellabschnitt (91a) steuert, um den Strom zu ändern, und der eine Strom-Spannungskennlinieninformation erhält, bei der es sich um eine Information handelt, aus der eine Korrespondenzbeziehung zwischen einem Stromwert und
einem Spannungswert, der durch den Spannungsmessabschnitt (91b) gemessen wird, hervorgeht; und
einen Negativspannungsgrundbestimmungsabschnitt (91c), der, falls die Spannung der Brennstoffzelle (20) eine Negativspannung ist, einen Grund für die Negativspannung der Brennstoffzelle (20) auf Basis der erhaltenen Strom-Spannungskennlinieninformation bestimmt,
wobei
in der Brennstoffzelle (20) ein Brenngas, das Wasserstoff enthält, und ein Oxidationsgas, das Sauerstoff enthält, als Reaktionsgase verwendet werden;
**dadurch gekennzeichnet, dass**
wenn die Strom-Spannungskennlinieninformation erhalten wird, der Strom-Spannungskennlinieninformationserhalteabschnitt (91b) den Spannungswert erhält, während er den Strom in einem Bereich ändert, in dem der Strom höher als 0 ist;
der Negativspannungsgrundbestimmungsabschnitt (91c) einen Nullstromzeit-Spannungswert, bei dem es sich um den Spannungswert zu einer Zeit handelt, da der Strom 0 beträgt, auf Basis der erhaltenen Strom-Spannungskennlinieninformation durch Extrapolation bestimmt;
wenn der Nullstromzeit-Spannungswert niedriger ist als 0, der Negativspannungsgrundbestimmungsabschnitt (91c) bestimmt, dass der Grund eine nicht ausreichende Menge an Wasserstoff ist;
wenn der Nullstromzeit-Spannungswert gleich oder höher als 0 Volt und niedriger als eine Leerlaufspannung der Brennstoffzelle (20) zu einer normalen Zeit ist, der Negativspannungsgrundbestimmungsabschnitt (91c) bestimmt, dass der Grund eine nicht ausreichende Menge an Sauerstoff ist; und
wenn der Nullstromzeit-Spannungswert gleich oder höher als die Leerlaufspannung ist, der Negativspannungsgrundbestimmungsabschnitt (91c) bestimmt, dass der Grund ein Austrocknen ist.

2. Brennstoffzelle nach Anspruch 1, wobei
die Brennstoffzelle (20) eine Katalysatorschicht und eine Oxidationsgaszuführleitung, durch die das Oxidationsgas der Katalysatorschicht zugeführt wird, beinhaltet;
wenn der Nullstromzeit-Spannungswert 0 Volt beträgt, der Negativspannungsgrundbestimmungsabschnitt (91c) bestimmt, dass der Grund die nicht ausreichende Menge an Sauerstoff aufgrund einer Verstopfung der Oxidationsgaszuführleitung ist; und
wenn der Nullstromzeit-Spannungswert höher als 0 Volt und niedriger als die Leerlaufspannung ist, der Negativspannungsgrundbestimmungsabschnitt (91 c) bestimmt, dass der Grund die nicht ausreichende Menge an Sauerstoff in einer Nähe der Katalysatorschicht ist.

3. Brennstoffzellensystem nach Anspruch 1 oder 2, wobei ein unterer Grenzwert in dem vorgegebenen Positivstrombereich höher ist als der Stromwert an einem Wendepunkt von dV/dI in einem Fall, bei dem der Grund die nicht ausreichende Menge an Sauerstoff oder das Austrocknen ist, wobei der dV/dI eine Änderung in dem Spannungswert im Verhältnis zu einer Änderung des Stromwerts anzeigt.

4. Brennstoffzellensystem, aufweisend:
eine Brennstoffzelle (20);
einen Spannungsmessabschnitt (91b), der eine Spannung der Brennstoffzelle (20) misst;
einen Stromeinstellabschnitt (91a), der einen Strom einstellt, der in der Brennstoffzelle (20) fließt;
einen Strom-Spannungskennlinieninformationserhalteabschnitt (91b), der den Stromeinstellabschnitt (91a) steuert, um den Strom zu ändern, und der eine Strom-Spannungskennlinieninformation erhält, bei der es sich um eine Information handelt, aus der eine Korrespondenzbeziehung zwischen einem Stromwert und
einem Spannungswert, der durch den Spannungsmessabschnitt (91b) gemessen wird, hervorgeht; und
einen Negativspannungsgrundbestimmungsabschnitt (91c), der, falls die Spannung der Brennstoffzelle (20) eine Negativspannung ist, einen Grund für die Negativspannung der Brennstoffzelle (20) auf Basis der erhaltenen Strom-Spannungskennlinieninformation bestimmt, wobei
in der Brennstoffzelle (20) ein Brenngas, das Wasserstoff enthält, und ein Oxidationsgas, das Sauerstoff enthält, als Reaktionsgase verwendet werden;
**dadurch gekennzeichnet, dass**
der Negativspannungsgrundbestimmungsabschnitt (91c) dV/dI, woraus eine Änderung des Spannungswerts im Verhältnis zu einer Änderung des Stromwerts hervorgeht, auf Basis der Strom-Spannungskennlinieninformation bestimmt;
falls es keinen Stromwertbereich gibt, in dem dV/dI konstant ist, der Negativspannungsgrundbestimmungsabschnitt (91c) bestimmt, dass der Grund eine nicht ausreichende Menge an Wasserstoff ist;
falls es den Stromwertbereich gibt, in dem dV/dI konstant ist und der Spannungswert an einem Wendepunkt von dV/dI niedriger ist als 0 Volt, der Negativspannungsgrundbestimmungsabschnitt (91c) bestimmt, dass der Grund eine nicht ausreichende Menge an Sauerstoff ist; und
falls es den Stromwertbereich gibt, in dem dV/dI konstant ist und der Spannungswert an dem Wendepunkt von dV/dI gleich oder höher ist als 0 Volt, der Negativspannungsgrundbestimmungsabschnitt (91c) bestimmt, dass der Grund ein Austrocknen ist.

5. Brennstoffzellensystem, aufweisend:
eine Brennstoffzelle (20);
einen Spannungsmessabschnitt (91b), der eine Spannung der Brennstoffzelle (20) misst;
einen Stromeinstellabschnitt (91a), der einen Strom einstellt, der in der Brennstoffzelle (20) fließt;
einen Strom-Spannungskennlinieninformationserhalteabschnitt (91b), der den Stromeinstellabschnitt (91a) steuert, um den Strom zu ändern, und der eine Strom-Spannungskennlinieninformation erhält, bei der es sich um eine Information handelt, aus der eine Korrespondenzbeziehung zwischen einem Stromwert und
einem Spannungswert, der durch den Spannungsmessabschnitt (91b) gemessen wird, hervorgeht; und
einen Negativspannungsgrundbestimmungsabschnitt (91c), der, falls die Spannung der Brennstoffzelle (20) eine Negativspannung ist, einen Grund für die Negativspannung der Brennstoffzelle (20) auf Basis der erhaltenen Strom-Spannungskennlinieninformation bestimmt, wobei
in der Brennstoffzelle (20) ein Brenngas, das Wasserstoff enthält, und ein Oxidationsgas, das Sauerstoff enthält, als Reaktionsgase verwendet werden;
die Brennstoffzelle (20) eine Katalysatorschicht und eine Oxidationsgaszuführleitung, durch die das Oxidationsgas der Katalysatorschicht zugeführt wird, beinhaltet;
**dadurch gekennzeichnet, dass**
der Negativspannungsgrundbestimmungsabschnitt (91c) dV/dI, woraus eine Änderung des Spannungswerts im Verhältnis zu einer Änderung des Stromwerts hervorgeht, auf Basis der Strom-Spannungskennlinieninformation bestimmt;
falls es keinen Stromwertbereich gibt, in dem dV/dI konstant ist, der Negativspannungsgrundbestimmungsabschnitt (91c) bestimmt, dass der Grund eine nicht ausreichende Menge an Wasserstoff ist;
falls es den Stromwertbereich gibt, in dem dV/dI konstant ist und es keinen Wendepunkt von dV/dI gibt, der Negativspannungsgrundbestimmungsabschnitt (91c) bestimmt, dass der Grund eine nicht ausreichende Menge an Sauerstoff aufgrund einer Verstopfung der Oxidationsgaszuführleitung ist; und
falls es den Stromwertbereich gibt, in dem dV/dI konstant ist und der Spannungswert an dem Wendepunkt von dV/dI niedriger ist als 0 Volt, der Negativspannungsgrundbestimmungsabschnitt (91c) bestimmt, dass der Grund die nicht ausreichende Menge an Sauerstoff in einer Nähe der Katalysatorschicht ist.

6. Brennstoffzellensystem nach Anspruch 5, wobei
falls es keinen Stromwertbereich gibt, in dem dV/dI konstant ist, der Negativspannungsgrundbestimmungsabschnitt (91c) bestimmt, dass der Grund eine nicht ausreichende Menge an Wasserstoff ist;
falls es den Stromwertbereich gibt, in dem dV/dI konstant ist und es keinen Wendepunkt von dV/dI gibt, der Negativspannungsgrundbestimmungsabschnitt (91c) bestimmt, dass der Grund eine nicht ausreichende Menge an Sauerstoff aufgrund einer Verstopfung der Oxidationsgaszuführleitung ist;
falls es den Stromwertbereich gibt, in dem dV/dI konstant ist und der Spannungswert an dem Wendepunkt von dV/dI niedriger ist als 0 Volt, der Negativspannungsgrundbestimmungsabschnitt (91c) bestimmt, dass der Grund die nicht ausreichende Menge an Sauerstoff in einer Nähe der Katalysatorschicht ist;
und
falls es den Stromwertbereich gibt, in dem dV/dI konstant ist und der Spannungswert an dem Wendepunkt gleich oder höher ist als 0 Volt, der Negativspannungsgrundbestimmungsabschnitt (91c) bestimmt, dass der Grund ein Austrocknen ist.

7. Brennstoffzellensystem nach Anspruch 2, 5 oder 6, ferner aufweisend:
einen Temperatureinstellabschnitt, der eine Temperatur der Brennstoffzelle (20) auf 0 °C oder mehr einstellt, falls bestimmt wird, dass der Grund die nicht ausreichende Menge an Sauerstoff aufgrund der Verstopfung der Oxidationsgaszuführleitung ist; und
einen Oxidationsgaszuführabschnitt (91d, 65), der eine Menge des Oxidationsgases, das der Brennstoffzelle (20) zugeführt wird, erhöht, wenn bestimmt wurde, dass der Grund die nicht ausreichende Menge an Sauerstoff aufgrund der Verstopfung der Oxidationsgaszuführleitung ist und die Temperatur der Brennstoffzelle (20) auf 0 °C oder mehr eingestellt wurde.

8. Brennstoffzellensystem nach Anspruch 7, ferner aufweisend:
einen Störungserfassungsabschnitt (91 g), der erfasst, dass in dem Brennstoffzellensystem eine Störung vorliegt, falls der Spannungswert ein Negativspannungswert ist, nachdem die Menge an zugeführtem Oxidationsgas durch den Oxidationsgaszuführabschnitt (91 d, 65) erhöht wurde.

9. Brennstoffzellensystem nach einem der Ansprüche 1 bis 6, ferner aufweisend:
einen Oxidationsgaszuführabschnitt (91d, 65), der eine Menge des Oxidationsgases, das der Brennstoffzelle (20) zugeführt wird, erhöht, falls bestimmt wird, dass der Grund die nicht ausreichende Menge an Sauerstoff ist;
einen Brenngaszuführabschnitt (91d, 71, 72), der eine Menge des Brenngases, das der Brennstoffzelle (20) zugeführt wird, erhöht, falls bestimmt wird, dass der Grund die nicht ausreichende Menge an Wasserstoff ist; und
einen Befeuchtungsabschnitt (91 e, 66), der die Brennstoffzelle (20) befeuchtet, falls bestimmt wird, dass der Grund das Austrocknen ist.

10. Verfahren zum Bestimmen eines Grunds für eine Negativspannung einer Brennstoffzelle, aufweisend:
Erhalten einer Strom-Spannungskennlinieninformation, bei der es sich um eine Information handelt, aus der eine Korrespondenzbeziehung zwischen einem Stromwert und einem Spannungswert hervorgeht, durch Ändern eines Stroms, der in der Brennstoffzelle (20) fließt und durch Messen einer Spannung der Brennstoffzelle (20); und
Bestimmen des Grunds für die Negativspannung der Brennstoffzelle (20) auf Basis der erhaltenen Strom-Spannungskennlinieninformation, wobei in der Brennstoffzelle (20) ein Brenngas, das Wasserstoff enthält, und ein Oxidationsgas, das Sauerstoff enthält, als Reaktionsgase verwendet werden;
**dadurch gekennzeichnet, dass**
wenn die Strom-Spannungskennlinieninformation erhalten wird, der Spannungswert erhalten wird, während der Strom in einem Bereich geändert wird, in dem der Strom höher als 0 ist;
ein Nullstromzeit-Spannungswert auf Basis der erhaltenen Strom-Spannungskennlinieninformation durch Extrapolation bestimmt wird, bei dem es sich um den Spannungswert zu einer Zeit handelt, da der Strom 0 ist;
wenn der Nullstromzeit-Spannungswert niedriger ist als 0 Volt, bestimmt wird, dass der Grund für die Negativspannung eine nicht ausreichende Menge an Wasserstoff ist;
wenn der Nullstromzeit-Spannungswert gleich oder höher ist als 0 Volt und niedriger ist als eine Leerlaufspannung der Brennstoffzelle (20) zu einer normalen Zeit, bestimmt wird, dass der Grund für die Negativspannung eine nicht ausreichende Menge an Sauerstoff ist; und
wenn der Nullstromzeit-Spannungswert gleich oder höher ist als die Leerlaufspannung, ein Austrocknen als der Grund für die Negativspannung bestimmt wird.

11. Verfahren zum Bestimmen eines Grunds für eine Negativspannung einer Brennstoffzelle, aufweisend:
Erhalten einer Strom-Spannungskennlinieninformation, bei der es sich um eine Information handelt, aus der eine Korrespondenzbeziehung zwischen einem Stromwert und einem Spannungswert hervorgeht, durch Ändern eines Stroms, der in der Brennstoffzelle (20) fließt und durch Messen einer Spannung der Brennstoffzelle (20); und
Bestimmen des Grunds für die Negativspannung der Brennstoffzelle (20) auf Basis der erhaltenen Strom-Spannungskennlinieninformation, wobei in der Brennstoffzelle (20) ein Brenngas, das Wasserstoff enthält, und ein Oxidationsgas, das Sauerstoff enthält, als Reaktionsgase verwendet werden;
**dadurch gekennzeichnet, dass**
dV/dI, woraus eine Änderung des Spannungswerts im Verhältnis zu einer Änderung des Stromwerts hervorgeht, auf Basis der Strom-Spannungskennlinieninformation bestimmt wird;
falls es keinen Stromwertbereich gibt, in dem dV/dI konstant ist, eine nicht ausreichende Menge an Wasserstoff als der Grund für die Negativspannung bestimmt wird;
falls es den Stromwertbereich gibt, in dem dV/dI konstant ist und der Spannungswert an einem Wendepunkt von dV/dI niedriger ist als 0 Volt, eine nicht ausreichende Menge an Sauerstoff als der Grund für die Negativspannung bestimmt wird; und
falls es den Stromwertbereich gibt, in dem dV/dI konstant ist und der Spannungswert an dem Wendepunkt gleich oder höher ist als 0 Volt, ein Austrocknen als der Grund für die Negativspannung bestimmt wird.

12. Verfahren zum Bestimmen eines Grunds für eine Negativspannung einer Brennstoffzelle, aufweisend:
Erhalten einer Strom-Spannungskennlinieninformation, bei der es sich um eine Information handelt, aus der eine Korrespondenzbeziehung zwischen einem Stromwert und einem Spannungswert hervorgeht, durch Ändern eines Stroms, der in der Brennstoffzelle (20) fließt und durch Messen einer Spannung der Brennstoffzelle (20); und
Bestimmen des Grunds für die Negativspannung der Brennstoffzelle (20) auf Basis der erhaltenen Strom-Spannungskennlinieninformation, wobei in der Brennstoffzelle (20) ein Brenngas, das Wasserstoff enthält, und ein Oxidationsgas, das Sauerstoff enthält, als Reaktionsgase verwendet werden;
wobei die Brennstoffzelle (20) eine Katalysatorschicht und eine Oxidationsgaszuführleitung, durch die das Oxidationsgas der Katalysatorschicht zugeführt wird, beinhaltet;
**dadurch gekennzeichnet, dass**
dV/dI, woraus eine Änderung des Spannungswerts im Verhältnis zu einer Änderung des Stromwerts hervorgeht, auf Basis der Strom-Spannungskennlinieninformation bestimmt wird;
falls es keinen Stromwertbereich gibt, in dem dV/dI konstant ist, eine nicht ausreichende Menge an Wasserstoff als der Grund für die Negativspannung bestimmt wird;
falls es den Stromwertbereich gibt, in dem dV/dI konstant ist und es keinen Wendepunkt von dV/dI gibt, eine nicht ausreichende Menge an Sauerstoff aufgrund einer Verstopfung der Oxidationsgaszuführleitung als der Grund der Negativspannung bestimmt wird; und
falls es den Stromwertbereich gibt, in dem dV/dI konstant ist und der Spannungswert an dem Wendepunkt von dV/dI niedriger ist als 0 Volt, eine nicht ausreichende Menge an Sauerstoff in einer Nähe der Katalysatorschicht als der Grund für die Negativspannung bestimmt wird.

13. Verfahren zum Bestimmen eines Grunds für eine Negativspannung einer Brennstoffzelle nach Anspruch 12, wobei
falls es keinen Stromwertbereich gibt, in dem dV/dI konstant ist, eine nicht ausreichende Menge an Wasserstoff als der Grund für die Negativspannung bestimmt wird;
falls es den Stromwertbereich gibt, in dem dV/dI konstant ist und es keinen Wendepunkt von dV/dI gibt, eine nicht ausreichende Menge an Sauerstoff aufgrund einer Verstopfung der Oxidationsgaszuführleitung als der Grund der Negativspannung bestimmt wird;
falls es den Stromwertbereich gibt, in dem dV/dI konstant ist und der Spannungswert an dem Wendepunkt von dV/dI niedriger ist als 0 Volt, eine nicht ausreichende Menge an Sauerstoff in einer Nähe der Katalysatorschicht als der Grund für die Negativspannung bestimmt wird; und
falls es den Stromwertbereich gibt, in dem dV/dI konstant ist und der Spannungswert an dem Wendepunkt gleich oder höher ist als 0 Volt, ein Austrocknen als der Grund für die Negativspannung bestimmt wird.

## Revendications

1. Système de pile à combustible comprenant:
une pile à combustible (20) ;
une partie de mesure de tension (91b) qui mesure une tension de la pile à combustible (20) ;
une partie de réglage de courant électrique (91a) qui règle un courant électrique circulant dans la pile à combustible (20);
une partie d'obtention d'information de caractéristique électrique courant-tension (91b) qui commande la partie de réglage de courant électrique (91a) pour modifier le courant électrique, et obtient une information de caractéristique électrique courant-tension qui est une information indiquant une relation de correspondance entre une valeur de courant électrique et une valeur de tension mesurée par la partie de mesure de tension (91b) ; et
une partie de détermination de cause de tension négative (91c) qui détermine, si la tension de la pile à combustible (20) est une tension négative, une cause de la tension négative de la pile à combustible (20), en fonction de l'information de caractéristique électrique courant-tension obtenue,
dans lequel,
dans la pile à combustible (20), un gaz combustible contenant de l'hydrogène et un gaz oxydant contenant de l'oxygène sont utilisés comme gaz de réaction ;
**caractérisé en ce que**
quand l'information de caractéristique électrique courant-tension est obtenue, la partie d'obtention d'information de caractéristique électrique courant- tension (91b) obtient la valeur de la tension pendant le changement de courant électrique dans une plage dans laquelle le courant électrique est supérieur à 0 ;
la partie de détermination de cause de tension négative (91c) détermine une valeur de tension à courant nul qui est la valeur de tension à un moment où le courant électrique est de 0, en fonction de l'information de caractéristique électrique courant-tension obtenue, en utilisant une extrapolation ;
si la valeur de tension à courant nul est inférieure à 0 volt, la partie de détermination de cause de tension négative (91c) détermine que la cause est l'insuffisance d'une quantité d'hydrogène ;
si la valeur de tension à courant nul est supérieure ou égale à 0 volt et inférieure à une tension en circuit ouvert de la pile à combustible (20) à un moment normal, la partie de détermination de cause de tension négative (91c) détermine que la cause est l'insuffisance d'une quantité d'oxygène ; et
si la valeur de tension à courant nul est supérieure ou égale à la tension en circuit ouvert, la partie de détermination de cause de tension négative (91c) détermine que la cause est l'assèchement.

2. Système de pile à combustible selon la revendication 1, dans lequel
la pile à combustible (20) inclut une couche catalytique, et un passage d'alimentation en gaz oxydant par lequel le gaz oxydant est fourni à la couche catalytique ;
si la valeur de tension à courant nul est de 0 volt, la partie de détermination de cause de tension négative (91c) détermine que la cause est l'insuffisance de la quantité d'oxygène due au blocage du passage d'alimentation en gaz oxydant ; et
si la valeur de tension à courant nul est supérieure à 0 volt et inférieure à la tension en circuit ouvert, la partie de détermination de cause de tension négative (91c) détermine que la cause est l'insuffisance de la quantité d'oxygène au voisinage de la couche catalytique.

3. Système de pile à combustible selon la revendication 1 ou 2, dans lequel
une valeur limite inférieure dans la plage de valeurs de courant électrique positive prédéterminée est supérieure à la valeur de courant électrique en un point d'inflexion de dV/dI dans un cas où la cause est l'insuffisance de la quantité d'oxygène ou l'assèchement, le dV/dI indiquant une variation de la valeur de tension relativement à une variation de la valeur du courant électrique.

4. Système de pile à combustible comprenant:
une pile à combustible (20) ;
une partie de mesure de tension (91b) qui mesure une tension de la pile à combustible (20) ;
une partie de réglage de courant électrique (91a) qui règle un courant électrique circulant dans la pile à combustible (20);
une partie d'obtention d'information de caractéristique électrique courant-tension (91b) qui commande la partie de réglage de courant électrique (91a) pour modifier le courant électrique, et obtient une information de caractéristique électrique courant-tension qui est une information indiquant une relation de correspondance entre une valeur de courant électrique et une valeur de tension mesurée par la partie de mesure de tension (91b) ; et
une partie de détermination de cause de tension négative (91c) qui détermine, si la tension de la pile à combustible (20) est une tension négative, une cause de la tension négative de la pile à combustible (20), en fonction de l'information de caractéristique électrique courant-tension obtenue, dans lequel,
dans la pile à combustible (20), un gaz combustible contenant de l'hydrogène et un gaz oxydant contenant de l'oxygène sont utilisés comme gaz de réaction ;
**caractérisé en ce que**
la partie de détermination de cause de tension négative (91c) détermine dV/dI qui indique une variation de la valeur de tension relativement à une variation de la valeur du courant électrique, en fonction de l'information de caractéristique électrique courant-tension ;
s'il n'y a pas une plage de valeurs de courant électrique dans laquelle le dV/dI est constant, la partie de détermination de cause de tension négative (91c) détermine que la cause est l'insuffisance d'une quantité d'hydrogène ;
s'il y a la plage de valeurs de courant électrique dans laquelle le dV/dI est constant et la valeur de tension en un point d'inflexion du dV/dI est inférieure à 0 volt, la partie de détermination de cause de tension négative (91c) détermine que la cause est l'insuffisance d'une quantité d'oxygène ; et
s'il y a la plage de valeurs de courant électrique dans laquelle le dV/dI est constant et la valeur de tension au niveau du point d'inflexion est supérieure ou égale à 0 volt, la partie de détermination de cause de tension négative (91c) détermine que la cause est l'assèchement.

5. Système de pile à combustible comprenant:
une pile à combustible (20) ;
une partie de mesure de tension (91b) qui mesure une tension de la pile à combustible (20) ;
une partie de réglage de courant électrique (91a) qui règle un courant électrique circulant dans la pile à combustible (20);
une partie d'obtention d'information de caractéristique électrique courant-tension (91b) qui commande la partie de réglage de courant électrique (91a) pour modifier le courant électrique, et obtient une information de caractéristique électrique courant-tension qui est une information indiquant une relation de correspondance entre une valeur de courant électrique et une valeur de tension mesurée par la partie de mesure de tension (91b) ; et
une partie de détermination de cause de tension négative (91c) qui détermine, si la tension de la pile à combustible (20) est une tension négative, une cause de la tension négative de la pile à combustible (20), en fonction de l'information de caractéristique électrique courant-tension obtenue, dans lequel,
dans la pile à combustible (20), un gaz combustible contenant de l'hydrogène et un gaz oxydant contenant de l'oxygène sont utilisés comme gaz de réaction ;
la pile à combustible (20) inclut une couche catalytique, et un passage d'alimentation en gaz oxydant par lequel le gaz oxydant est fourni à la couche catalytique ;
**caractérisé en ce que**
la partie de détermination de cause de tension négative (91c) détermine dV/dI qui indique une variation de la valeur de tension relativement à une variation de la valeur du courant électrique, en fonction de l'information de caractéristique électrique courant-tension;
s'il n'y a pas une plage de valeurs de courant électrique dans laquelle le dV/dI est constant, la partie de détermination de cause de tension négative (91c) détermine que la cause est l'insuffisance d'une quantité d'hydrogène ;
s'il y a la plage de valeurs de courant électrique dans laquelle le dV/dI est constant et il n'y a pas de point d'inflexion du dV/dI, la partie de détermination de cause de tension négative (91c) détermine que la cause est l'insuffisance d'une quantité d'oxygène due au blocage du passage d'alimentation en gaz oxydant ; et
s'il y a la plage de valeurs de courant électrique dans laquelle le dV/dI est constant et la valeur de la tension au point d'inflexion du dV/dI est inférieure à 0 volt, la partie de détermination de cause de tension négative (91c) détermine que la cause est l'insuffisance de la quantité d'oxygène au voisinage de la couche catalytique.

6. Système de pile à combustible selon la revendication 5, dans lequel
s'il n'y a pas une plage de valeurs de courant électrique dans laquelle le dV/dI est constant, la partie de détermination de cause de tension négative (91c) détermine que la cause est l'insuffisance d'une quantité d'hydrogène ;
s'il y a la plage de valeurs de courant électrique dans laquelle le dV/dI est constant et il n'y a pas de point d'inflexion du dV/dI, la partie de détermination de cause de tension négative (91c) détermine que la cause est l'insuffisance d'une quantité d'oxygène due au blocage du passage d'alimentation en gaz oxydant ;
s'il y a la plage de valeurs de courant électrique dans laquelle le dV/dI est constant et la valeur de la tension au point d'inflexion du dV/dI est inférieure à 0 volt, la partie de détermination de cause de tension négative (91c) détermine que la cause est l'insuffisance de la quantité d'oxygène au voisinage de la couche catalytique ; et
s'il y a la plage de valeurs de courant électrique dans laquelle le dV/dI est constant et la valeur de tension au niveau du point d'inflexion est supérieure ou égale à 0 volt, la partie de détermination de cause de tension négative (91c) détermine que la cause est l'assèchement.

7. Système de pile à combustible selon la revendication 2, 5, ou 6, comprenant en outre:
une partie de réglage de température qui règle une température de la pile à combustible (20) à 0 °C ou plus, s'il est déterminé que la cause est l'insuffisance de la quantité d'oxygène due au blocage du passage d'alimentation en gaz oxydant ; et
une partie d'alimentation en gaz oxydant (91d, 65) qui augmente une quantité du gaz oxydant fournie à la pile à combustible (20), s'il a été déterminé que la cause est l'insuffisance de la quantité d'oxygène due au blocage du passage d'alimentation en gaz oxydant et la température de la pile à combustible (20) a été réglée à 0 °C ou plus.

8. Système de pile à combustible selon la revendication 7, comprenant en outre
une partie de détection de dysfonctionnement (91g) qui détecte qu'un dysfonctionnement a eu lieu dans le système de pile à combustible, si la valeur de tension est une valeur de tension négative après que la quantité de gaz oxydant fournie est augmentée par la partie d'alimentation en gaz oxydant (91d, 65).

9. Système de pile à combustible selon l'une quelconque des revendications 1 à 6, comprenant en outre :
une partie d'alimentation en gaz oxydant (91d, 65) qui augmente une quantité du gaz oxydant fournie à la pile à combustible (20), s'il est déterminé que la cause est l'insuffisance de la quantité d'oxygène ;
une partie d'alimentation en gaz combustible (91d, 71, 72) qui augmente une quantité du gaz combustible fourni à la pile à combustible (20), s'il est déterminé que la cause est l'insuffisance de la quantité d'hydrogène ; et
une partie d'humidification (91e, 66) qui humidifie la pile à combustible (20), s'il est déterminé que la cause est l'assèchement.

10. Procédé de détermination d'une cause d'une tension négative d'une pile à combustible, comprenant:
d'obtenir une information de caractéristique électrique courant-tension qui est une information indiquant une relation de correspondance entre une valeur de courant électrique et une valeur de tension, en modifiant un courant électrique circulant dans la pile à combustible (20), et en mesurant une tension de la pile à combustible (20) ; et
de déterminer la cause de la tension négative de la pile à combustible (20), en fonction de l'information de caractéristique électrique courant-tension obtenue, dans lequel,
dans la pile à combustible (20), un gaz combustible contenant de l'hydrogène et un gaz oxydant contenant de l'oxygène sont utilisés comme gaz de réaction ;
**caractérisé en ce que**,
quand l'information de caractéristique électrique courant-tension est obtenue, la valeur de la tension est obtenue pendant le changement du courant électrique dans une plage dans laquelle le courant électrique est supérieur à 0 ;
une valeur de tension à courant nul est déterminée qui est la valeur de tension à un moment où le courant électrique est de 0, en fonction de l'information de caractéristique électrique courant-tension obtenue, en utilisant une extrapolation ;
si la valeur de tension à courant nul est inférieure à 0 volt, l'insuffisance d'une quantité d'hydrogène est déterminée comme la cause de la tension négative ;
si la valeur de tension à courant nul est supérieure ou égale à 0 volt et inférieure à une tension en circuit ouvert de la pile à combustible (20) à un moment normal, l'insuffisance d'une quantité d'oxygène est déterminée comme la cause de la tension négative ; et
si la valeur de tension à courant nul est supérieure ou égale à la tension en circuit ouvert, l'assèchement est déterminé comme la cause de la tension négative.

11. Procédé de détermination d'une cause d'une tension négative d'une pile à combustible, comprenant:
d'obtenir une information de caractéristique électrique courant-tension qui est une information indiquant une relation de correspondance entre une valeur de courant électrique et une valeur de tension, en modifiant un courant électrique circulant dans la pile à combustible (20), et en mesurant une tension de la pile à combustible (20) ; et
de déterminer la cause de la tension négative de la pile à combustible (20), en fonction de l'information de caractéristique électrique courant-tension obtenue, dans lequel,
dans la pile à combustible (20), un gaz combustible contenant de l'hydrogène et un gaz oxydant contenant de l'oxygène sont utilisés comme gaz de réaction ;
**caractérisé en ce que**,
dV/dI qui indique une variation de la valeur de tension relativement à une variation de la valeur du courant électrique, est déterminé en fonction de l'information de caractéristique électrique courant-tension ;
s'il n'y a pas une plage de valeurs de courant électrique dans laquelle le dV/dI est constant, l'insuffisance d'une quantité d'hydrogène est déterminée comme la cause de la tension négative ;
s'il y a la plage de valeurs de courant électrique dans laquelle le dV/dI est constant et la valeur de tension en un point d'inflexion du dV/dI est inférieure à 0 volt, l'insuffisance d'une quantité d'oxygène est déterminée comme la cause de la tension négative ; et
s'il y a la plage de valeurs de courant électrique dans laquelle le dV/dI est constant et la valeur de tension au niveau du point d'inflexion est supérieure ou égale à 0 volt, l'assèchement déterminé comme la cause de la tension négative.

12. Procédé de détermination d'une cause d'une tension négative d'une pile à combustible, comprenant:
d'obtenir une information de caractéristique électrique courant-tension qui est une information indiquant une relation de correspondance entre une valeur de courant électrique et une valeur de tension, en modifiant un courant électrique circulant dans la pile à combustible (20), et en mesurant une tension de la pile à combustible (20) ; et
de déterminer la cause de la tension négative de la pile à combustible (20), en fonction de l'information de caractéristique électrique courant-tension obtenue, dans lequel,
dans la pile à combustible (20), un gaz combustible contenant de l'hydrogène et un gaz oxydant contenant de l'oxygène sont utilisés comme gaz de réaction ; et
la pile à combustible (20) comprend une couche catalytique, et un passage d'alimentation en gaz oxydant par lequel le gaz oxydant est fourni à la couche catalytique ;
**caractérisé en ce que**
dV/dI, qui indique une variation de la valeur de tension relativement à une variation de la valeur du courant électrique, est déterminé en fonction de l'information de caractéristique électrique courant-tension ;
s'il n'y a pas une plage de valeurs de courant électrique dans laquelle le dV/dI est constant, l'insuffisance d'une quantité d'hydrogène est déterminée comme la cause de la tension négative ;
s'il y a la plage de valeurs de courant électrique dans laquelle le dV/dI est constant et il n'y a pas de point d'inflexion du dV/dI, l'insuffisance d'une quantité d'oxygène due au blocage du passage d'alimentation en gaz oxydant est déterminée comme la cause de la tension négative ; et
s'il y a la plage de valeurs de courant électrique dans laquelle le dV/dI est constant et la valeur de la tension au point d'inflexion du dV/dI est inférieure à 0 volt, l'insuffisance de la quantité d'oxygène au voisinage de la couche catalytique est déterminée comme la cause de la tension négative.

13. Procédé de détermination d'une cause d'une tension négative d'une pile à combustible selon la revendication 12, dans lequel,
s'il n'y a pas de plage de valeurs de courant électrique dans laquelle le dV/dI est constant, l'insuffisance d'une quantité d'hydrogène est déterminée comme la cause de la tension négative ;
s'il y a la plage de valeurs de courant électrique dans laquelle le dV/dI est constant et il n'y a pas de point d'inflexion du dV/dI, l'insuffisance de la quantité d'oxygène due au blocage du passage d'alimentation en gaz oxydant est déterminée comme la cause de la tension négative ;
s'il y a la plage de valeurs de courant électrique dans laquelle le dV/dI est constant et la valeur de la tension au point d'inflexion du dV/dI est inférieure à 0 volt, l'insuffisance de la quantité d'oxygène au voisinage de la couche catalytique est déterminée comme la cause de la tension négative ; et
s'il y a la plage de valeurs de courant électrique dans laquelle le dV/dI est constant et la valeur de tension au niveau du point d'inflexion est supérieure ou égale à 0 volt, l'assèchement est déterminé comme la cause de la tension négative.
